# EUROPEAN PATENT APPLICATION

(11) **EP 4 654 782 A1**
(43) Date of publication of application: **26.11.2025**
(21) Application number: 25153807.0
(22) Date of filing: 24.01.2025
(51) Int. Cl.: H10D 64/01, H10D 30/01, H10D 30/00, H10D 64/23, H10D 30/67

(54) **SEMICONDUCTOR DEVICE**

(30) Priority: 23.05.2024 KR 20240067224
(71) Applicant: Samsung Electronics Co., Ltd., Suwon-si, Gyeonggi-do 16677 (KR)
(72) Inventor: LEE, Minseung, 16677 Suwon-si, Gyeonggi-do (KR); LEE, Kyoungwoo, 16677 Suwon-si, Gyeonggi-do (KR); HA, Seungseok, 16677 Suwon-si, Gyeonggi-do (KR)
(74) Representative: Kuhnen & Wacker Patent- und Rechtsanwaltsbüro PartG mbB

(57) **Abstract**

An example semiconductor device includes a substrate (10), a channel layer (CH) disposed on the substrate (10), a gate structure (GS) surrounding the channel layer (CH), source/drain patterns connected with both sides of the channel layer (CH), a lower wiring structure (410) disposed below the substrate (10), and an insulating pattern extending through the substrate (10) and disposed between the source/drain patterns below the gate structure (GS). The insulating pattern includes a sub-insulating pattern (211) disposed below the gate structure (GS) and a main insulating pattern (212) disposed between the sub-insulating pattern (211) and the lower wiring structure (410). The sub-insulating pattern (211) and the main insulating pattern (212) include different insulating materials.

## Description

### BACKGROUND

Semiconductor devices are used in various electronic devices, such as storage devices that store data and processors that compute and process data. As the electronics industry develops, various methods are being researched to improve various characteristics such as integration, reliability, speed, and function of semiconductor devices. For example, in order to overcome limitations caused by reduction in the size of semiconductor devices, semiconductor devices with a three-dimensional structure is being proposed.

Recently, research is being conducted to improve routing congestion and scale the size of semiconductor devices by disposing a power delivery network on the back of the substrate to route signals provided to semiconductor devices.

### SUMMARY

The present disclosure relates to a semiconductor device with improved reliability and a manufacturing method thereof.

The present disclosure relates to a semiconductor device with improved electrical characteristics and a manufacturing method thereof.

The present disclosure is not limited to the objects mentioned above, and other objects not mentioned can be clearly understood by those skilled in the art from the description below.

In some implementations, a semiconductor device includes: a substrate; a channel layer disposed on the substrate; a gate structure surrounding the channel layer; source/drain patterns connected to both sides of the channel layer; a lower wiring structure disposed below the substrate; and an insulating pattern penetrating the substrate and disposed between the source/drain patterns below the gate structure, wherein the insulating pattern includes a sub-insulating pattern disposed below the gate structure and a main insulating pattern disposed between the sub-insulating pattern and the lower wiring structure, and the sub-insulating pattern and the main insulating pattern include different insulating materials.

In some implementations, a manufacturing method of a semiconductor device includes: forming a channel layer, a gate structure surrounding the channel layer, and source/drain patterns respectively connected to both sides of the channel layers, on a substrate; forming an insulating pattern that penetrates the substrate under the gate structure and includes a sub-insulating pattern and a main insulating pattern; and forming a lower wiring structure below the substrate, wherein the forming of the insulating pattern includes forming a trench that penetrates the substrate and is adjacent to a lower surface of the gate structure; forming a sub-insulating pattern between the trench and the gate structure; and forming a main insulating pattern that fills the inside of the trench, and the sub-insulating pattern and the main insulating pattern include different insulating materials.

In some implementations, a semiconductor device includes: a lower pattern; a channel layer disposed on the lower pattern; a gate structure surrounding the channel layer; source/drain patterns respectively connected to both sides of the channel layer; a lower wiring structure disposed below the lower pattern; a through electrode that penetrates the lower pattern and is disposed between at least some of the source/drain patterns and the lower wiring structure; and an insulating liner disposed between a side surface of the through electrode and the lower pattern, wherein the insulating liner has a lower nitrogen concentration as it gets farther from the side surface of the through electrode toward the lower pattern.

In some implementations, at least a portion of the insulating pattern disposed between two source/drain patterns may be formed through a nitridation process. In the etching process for forming the insulating pattern, other insulating layers may not be damaged by the etching material, thereby improving the reliability of the semiconductor device may be improved.

In some implementations, the insulating liner film between the back contact electrode and the substrate may be formed by a nitridation process, and in this case, the volume of the back contact electrode may increase compared to the existing process, thereby improving the electrical characteristics of the semiconductor device.

### BRIEF DESCRIPTION OF THE DRAWINGS

FIG. 1 illustrates a top plan view of an example of a semiconductor device.
FIG. 2 illustrates an example cross-sectional view of the semiconductor device taken along line I1-I1' of FIG. 1.
FIG. 3 illustrates an example cross-sectional view of the semiconductor device taken along line I2-I2' of FIG. 1.
FIG. 4 illustrates an example cross-sectional view of a semiconductor device.
FIG. 5 illustrates an example cross-sectional view of a semiconductor device.
FIG. 6, FIG. 7, FIG. 8, FIG. 9, FIG. 10, FIG. 11, FIG. 12, FIG. 13, and FIG. 14 are drawings for explaining an example of a manufacturing method of a semiconductor device.
FIG. 15 illustrates a top plan view of an example of a semiconductor device.
FIG. 16 illustrates an example cross-sectional view of the semiconductor device taken along line I3- 13' of FIG. 1.
FIG. 17 illustrates an example cross-sectional view of the semiconductor device taken along line I4-I4' of FIG. 15.
FIG. 18 illustrates an example cross-sectional view of the semiconductor device taken along line I5-I5' of FIG. 15.
FIG. 19 illustrates a cross-sectional view of an example of a semiconductor device.
FIG. 20, FIG. 21, FIG. 22, FIG. 23, FIG. 24, FIG. 25, FIG. 26, FIG. 27, and FIG. 28 are drawings for explaining an example of a manufacturing method of a semiconductor device.
FIG. 29 illustrates a top plan view of an example of a semiconductor device.
FIG. 30 illustrates an example cross-sectional view of the semiconductor device taken along line I6-I6' of FIG. 29.
FIG. 31 illustrates an example cross-sectional view of the semiconductor device taken along line I7-I7' of FIG. 29.
FIG. 32 illustrates an example cross-sectional view of the semiconductor device taken along line I8-I8' of FIG. 29.
FIG. 33, FIG. 34, FIG. 35, FIG. 36, FIG. 37, FIG. 38, FIG. 39, FIG. 40, FIG. 41, and FIG. 42 are drawings for explaining an example of a manufacturing method of a semiconductor device.

### DETAILED DESCRIPTION

The present disclosure will be described more fully hereinafter with reference to the accompanying drawings, in which implementations of the disclosure are shown. As those skilled in the art would realize, the described implementations may be modified in various different ways, all without departing from the scope of the present disclosure.

In order to clearly describe the present disclosure, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

In the drawing of a semiconductor device, illustratively, GAA (gate all around) including a nano wire or a nano sheet, MBCFET^{™} (multi-bridge channel field effect transistor) is shown, but is not limited thereto. In some implementations, a semiconductor device may include a fin-type transistor (FinFET), a tunneling transistor (tunneling FET), a 3D stack field effect transistor (3D-SFET) structure, and a complementary field effect transistor (CFET) structure, which include a fin-type pattern-shaped channel area.

Hereinafter, a semiconductor device will be described with reference to the accompanying drawings.

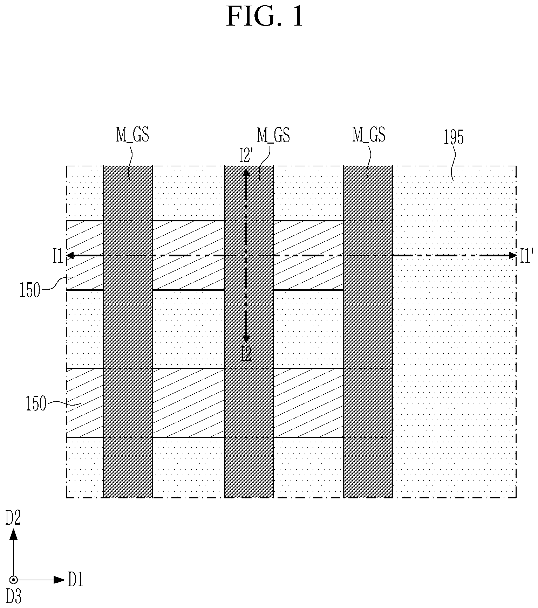

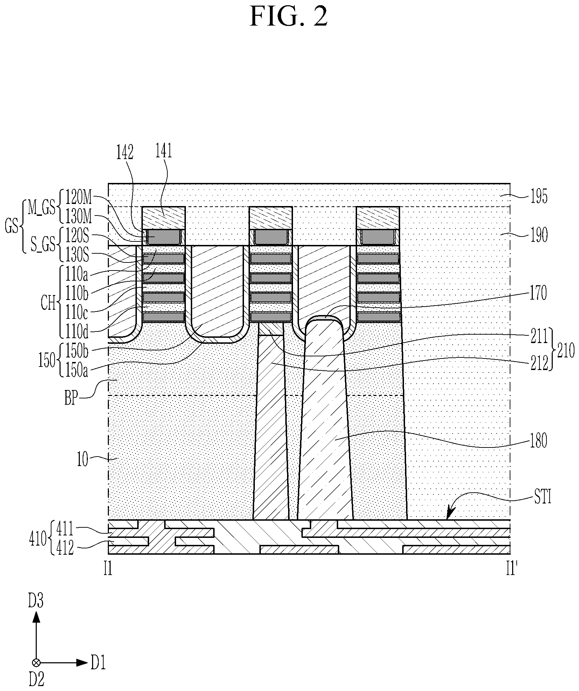

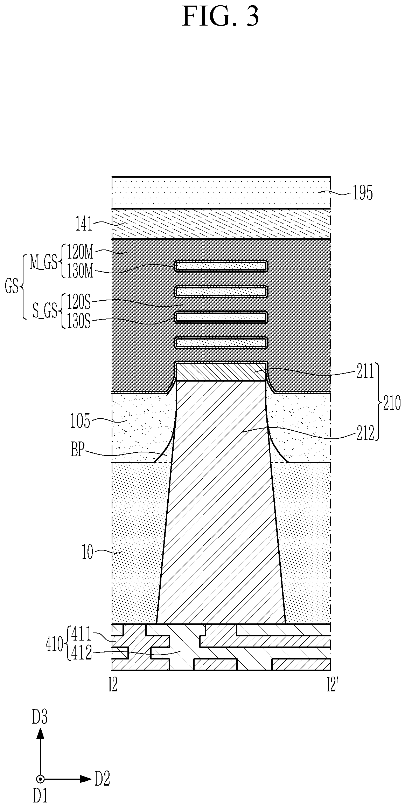

FIG. 1 illustrates a top plan view of an example of a semiconductor device. FIG. 2 and FIG. 3 illustrate example cross-sectional views of a semiconductor device. Specifically, FIG. 2 illustrates an example cross-sectional view of the semiconductor device taken along line 11-11' of FIG. 1, and FIG. 3 illustrates an example cross-sectional view of the semiconductor device taken along line I2-I2' of FIG. 1.

Referring to FIG. 1 to FIG. 3, a semiconductor device may include a substrate 10, channel layers CH disposed on the substrate 10, a gate structure GS surrounding the channel layers CH, source/drain patterns 150 disposed on both sides of each channel layer CH, a lower wiring structure 410 disposed below the substrate 10, and an insulating pattern 210 disposed between the source/drain patterns 150 below the gate structure GS.

The substrate 10 may be a silicon-on-insulator (SOI) or bulk silicon. Alternatively, the substrate 10 may be a silicon substrate, or may include other materials, such as a silicon germanium (SiGe), a silicon germanium on insulator (SGOI), an indium antimonide, a lead telluride, an indium arsenide, an indium phosphide, a gallium arsenide, or a gallium antimonide, but the present disclosure is not limited thereto.

In some implementations, the substrate 10 may be an insulating substrate. The substrate 10 may include an oxide, a nitride, an oxynitride, or a combination thereof. For example, the substrate 10 may include a silicon nitride (SiNₓ). Although the substrate 10 is illustrated as being a single film, it is only for better understanding and ease of description, but is not limited thereto.

The first and second surfaces of the substrate 10 may be formed as planes parallel to the first direction D1 and the second direction D2 crossing the first direction D1. For example, the first surface of the substrate 10 may be an upper surface, and the second surface may be a lower surface. The upper surface of the substrate 10 is opposite to the lower surface of the substrate 10 in the third direction D3. The third direction D3 may be a direction perpendicular to the first direction D1 and the second direction D2. The lower surface of the substrate 10 may be referred to as a back side of the substrate 10. In some implementations, the logic circuit of the cell area may be implemented on the upper surface of the substrate 10.

The semiconductor device may further include lower patterns BP disposed on the substrate 10. The lower patterns BP may be portions protruding from the first surface of the substrate 10 in the third direction D3. The lower patterns BP may be formed by etching a portion of the substrate 10, or may be grown from the substrate 10 through an epitaxial growth method.

The lower patterns BP may extend in the first direction D1. The lower patterns BP may be disposed on the first surface of the substrate 10 to be spaced apart from each other in the second direction D2. The source/drain patterns 150 to be described later may be disposed on the lower patterns BP. The source/drain patterns 150 may be disposed on respective lower patterns BP to be spaced apart from each other in the first direction D1.

The lower patterns BP may include silicon (Si) or germanium (Ge), which is an element semiconductor material. Alternatively, the lower patterns BP may include a compound semiconductor. For example, the lower patterns BP may include a group IV-IV compound semiconductor or a group III-V compound semiconductor. The group IV-IV compound semiconductor may be, for example, a binary compound or a ternary compound including carbon (C), silicon (Si), germanium (Ge), tin (Sn), or a combination thereof. The group III-V compound semiconductor may be, for example, a binary compound, a ternary compound, or a quaternary compound formed by combining aluminum (Al), gallium (Ga), indium (In) as a group III element, or a combination thereof, or phosphorus (P), arsenic (As), antimony (Sb) as a group V element, or a combination thereof.

The channel layers CH may be disposed on the first surface of the substrate 10. As illustrated in FIG. 2 and FIG. 3, when the lower pattern BP is disposed on the substrate 10, the channel layers CH may be disposed on the lower pattern BP. The channel layers CH may be disposed on the substrate 10 and/or the lower pattern BP to be spaced apart from each other in the first direction D1. Each of the channel layers CH may include a plurality of semiconductor layers 110a, 110b, 110c, and 110d disposed to be spaced apart from each other in the third direction D3. For example, each of the plurality of semiconductor layers 110a, 11 0b, 110c, and 110d may have a sheet shape. Each semiconductor layer may be a nanosheet having a thickness of several nanometers in the third direction D3.

The channel layer CH may provide a path through which a current flows between the source/drain patterns 150 to be described later. Referring to FIG. 2 and FIG. 3, the channel layer CH may be disposed between the source/drain patterns 150 to connect the source/drain patterns 150. The channel layers CH may penetrate a portion of the gate structure GS in a direction (for example, the first direction D1) crossing a direction in which the gate structure GS to be described later extends. In FIG. 2 and FIG. 3, the channel layers CH are illustrated as having four semiconductor layers 110a, 110b, 110c, and 110d disposed to be spaced apart from each other in the third direction D3, but are not limited thereto, and the number of stacked semiconductor layers 110a, 110b, 110c, and 110d included in one channel layer CH may be variously changed.

The channel layers CH may include a semiconductor material. For example, the channel layers CH may include a group IV semiconductor such as Si and Ge, a group III-V compound semiconductor, a group II-VI compound semiconductor, and the like. In some implementations, the lower pattern BP may be disposed below the channel layer CH. Specifically, the lower pattern BP may be disposed between a sub-gate structure S_GS disposed at the lowermost portion among a plurality of sub-gate structures S_GS to be described later and the substrate 10. The upper surface of the lower pattern BP may be in contact with the lower surface of the sub-gate structure S_GS disposed at the lowermost portion among the plurality of sub-gate structures S_GS.

In some implementations, unlike those illustrated in FIG. 2 and FIG. 3, the semiconductor device may not include the lower pattern BP. In this case, the lower surface of the sub-gate structure S_GS disposed at the lowermost portion among the sub-gate structures S_GS may be in direct contact with the substrate 10.

The semiconductor device may further include a field insulating layer 105 disposed on the substrate 10. The field insulating layer 105 may be disposed on the lower pattern BP. The field insulating layer 105 may be disposed on the side surface of the lower pattern BP. The field insulating layer 105 may not be disposed on the upper surface of the lower pattern BP. The field insulating layer 105 may entirely cover the side surface of the lower pattern BP. Unlike illustrated, the field insulating layer 105 may cover a portion of the side surface of the lower pattern BP. In this case, a portion of the lower pattern BP may protrude from the upper surface of the field insulating layer 105 in the third direction D3. The field insulating layer 105 may include, for example, an oxide, a nitride, an oxynitride, or a combination thereof. Although the field insulating layer 105 is illustrated as being a single film, it is only for better understanding and ease of description, but is not limited thereto.

The gate structure GS may be disposed on the substrate 10. The lower pattern BP or the field insulating layer 105 may be disposed between the gate structure GS and the substrate 10. The gate structure GS may extend on the substrate 10 in a direction different from a direction in which the lower pattern BP extends. For example, the gate structure GS may extend on the substrate 10 in a direction (for example, the second direction D2) crossing a direction in which the lower pattern BP extends. The gate structure GS may be disposed on the substrate 10. Plural of the gate structure GS may be disposed to be spaced apart from each other in the first direction D1. Each gate structure GS may include a sub-gate structure S_GS and a main gate structure M_GS. The sub-gate structure S_GS may be disposed on the substrate 10, and the main gate structure M_GS may be disposed on the sub-gate structure S_GS. As shown in the cross-sectional view illustrated in FIG. 3, the main gate structure M_GS may also be disposed on the field insulating layer 105. In this case, the sub-gate structure S_GS may not be disposed between the main gate structure M_GS and the field insulating layer 105.

Each of the sub-gate structures S_GS may be formed of several layers. For example, each of the sub-gate structures S_GS may include a sub-gate electrode 120S and a sub-gate insulating film 130S. The sub-gate structures S_GS and the semiconductor layers 110a, 110b, 110c, and 110d may be alternately stacked in the third direction D3. In FIG. 2 and FIG. 3, four sub-gate structures S_GS are shown as being arranged spaced apart from each other in the third direction D3, but the number of sub-gate structures S_GS arranged spaced apart from each other is not limited thereto. For example, the gate structure GS may include three sub-gate structures S_GS.

The sub-gate electrode 120S may be formed on the lower pattern BP. The sub-gate electrode 120S may cross the lower pattern BP. The sub-gate electrode 120S may cover the plurality of semiconductor layers 110a, 110b, 110c, and 110d. At least a portion of the sub-gate electrode 120S may be disposed on a structure in which the sub-gate electrode 120S and the plurality of semiconductor layers 110a, 110b, 110c, and 110d are alternately stacked. The sub-gate electrode 120S may surround four surfaces of the plurality of semiconductor layers 110a, 110b, 110c, and 110d together with the main gate electrode 120M.

The sub-gate electrode 120S may include at least one of a metal, a metal alloy, a conductive metal nitride, a metal silicide, a doped semiconductor material, a conductive metal oxide, and a conductive metal nitride. The sub-gate electrode 120S may include, for example, at least one of a titanium nitride (TiN), a tantalum carbide (TaC), a tantalum nitride (TaN), a titanium silicon nitride (TiSiN), a tantalum silicon nitride (TaSiN), a tantalum titanium nitride (TaTiN), a titanium aluminum nitride (TiAlN), a tantalum aluminum nitride (TaAlN), a tungsten nitride (WN), ruthenium (Ru), a titanium aluminum (TiAl), a titanium aluminum carbonitride (TiAlC-N), a titanium aluminum carbide (TiAlC), a titanium carbide (TiC), a tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), a niobium nitride (NbN), a niobium carbide (NbC), molybdenum (Mo), a molybdenum nitride (MoN), a molybdenum carbide (MoC), a tungsten carbide (WC), rhodium (Rh), palladium (Pd), iridium (Ir), osmium (Os), silver (Ag), gold (Au), zinc (Zn), vanadium (V), and a combination thereof, but is not limited thereto. The conductive metal oxide and the conductive metal oxynitride may include oxidized forms of the above-mentioned materials, but are not limited thereto.

The sub-gate insulating film 130S may extend along the upper surface of the lower pattern BP. The sub-gate insulating film 130S may be disposed along the circumference of the plurality of semiconductor layers 110a, 110b, 110c, and 110d. The sub-gate insulating film 130S may directly contact the lower pattern BP and the plurality of semiconductor layers 110a, 110b, 110c, and 110d. The sub-gate insulating film 130S may be interposed between the plurality of semiconductor layers 110a, 110b, 110c, and 110d and the sub-gate electrode 120S. The sub-gate insulating film 130S may include various insulating materials. Although not clearly disclosed in FIG. 2 and FIG. 3, the semiconductor device may further include an inner gate spacer disposed between the sub-gate insulating film 130S and the source/drain pattern 150 to be described later.

In some implementations, the sub-gate insulating film 130S is shown as a single film, but is not limited thereto. For example, the sub-gate insulating film 130S may be formed as a multifilm including a silicon oxide (SiO₂) and a high dielectric constant material. In this case, the high dielectric constant material may include a material having a higher dielectric constant than that of a silicon oxide (SiO₂) such as a hafnium oxide (HfO), an aluminum oxide (AlO), or a tantalum oxide (TaO).

The main gate structure M_GS may be disposed on the sub-gate structure S_GS and the plurality of semiconductor layers 110a, 110b, 110c, and 110d. The main gate structure M_GS may be disposed on the upper surface of the semiconductor layer 110a, which is disposed at the uppermost portion among the plurality of semiconductor layers 110a, 110b, 110c, and 110d. The main gate structure M_GS may also be disposed on the field insulating layer 105. The main gate structure M_GS may cover both lateral surfaces of the sub-gate structure S_GS.

The main gate structure M_GS may include a main gate electrode 120M and a main gate insulating film 130M.

The main gate electrode 120M may be disposed on the sub-gate structure S_GS and the plurality of semiconductor layers 110a, 110b, 110c, and 110d. The main gate electrode 120M may include the same material as the sub-gate electrode 120S. For example, the main gate electrode 120M may include at least one of a metal, a metal alloy, a conductive metal nitride, a metal silicide, a doped semiconductor material, a conductive metal oxide, and a conductive metal nitride.

The main gate insulating film 130M may extend along the side surface of the main gate electrode 120M. The main gate insulating film 130M may extend along a side surface of a gate spacer 142, which will be described later. The main gate insulating film 130M may include the same material as the sub-gate insulating film 130S. The main gate insulating film 130M may include various insulating materials.

In some implementations, the main gate insulating film 130M is shown as a single film, but is not limited thereto. For example, the main-gate insulating film 130M may be formed as a multifilm including a silicon oxide (SiO₂) and a high dielectric constant material. In this case, the high dielectric constant material may include a material having a higher dielectric constant than that of a silicon oxide (SiO₂) such as a hafnium oxide (HfO), an aluminum oxide (AlO), or a tantalum oxide (TaO).

According to some implementations, the semiconductor device may further include a capping layer 141 and a gate spacer 142.

The gate spacer 142 may be disposed on the side surface of the main gate electrode 120M. The gate spacer 142 may be disposed on the channel layer CH. The gate spacer 142 may not be disposed on the side surface of the sub-gate electrode 120S. The gate spacer 142 may not be disposed on the side surface of each of the semiconductor layers 110a, 110b, 110c, and 110d. Although the gate spacer 142 is illustrated as being a single film, it is only for better understanding and ease of description, but is not limited thereto.

The gate spacer 142 may include at least one of, for example, a silicon nitride (SiN), a silicon oxynitride (SiON), a silicon oxide (SiO₂), a silicon carbonate nitride (SiOCN), a silicon boron nitride (SiBN), a silicon oxyboron nitride (SiOBN), a silicon oxycarbide (SiOC), and a combination thereof. Although the gate spacer 142 is illustrated as being a single film, it is only for better understanding and ease of description, but is not limited thereto.

The capping layer 141 may be disposed on the main gate structure M_GS and the gate spacer 142. The upper surface of the capping layer 141 may be placed on the same plane as an upper surface of an interlayer insulating layer 190, which will be described later. Unlike shown, the capping layer 141 may be disposed between the gate spacers 142.

The capping layer 141 may include at least one of, for example, a silicon nitride (SiN), a silicon oxynitride (SiON), a silicon carbonitride (SiCN), a silicon carbonitride (SiOCN), and a combination thereof. The capping layer 141 may include a material having etch selectivity to the interlayer insulating layer 190, which will be described later.

The source/drain patterns 150 may be disposed on the substrate 10. The lower pattern BP may be disposed between the source/drain patterns 150 and the substrate 10. However, it is not limited thereto, and the lower pattern BP may not be disposed between the source/drain pattern 150 and the substrate 10. The channel layer CH and the gate structure GS may be disposed between the source/drain patterns 150. In other words, a plurality of source/drain patterns 150 and a plurality of channel layers CH may be alternately arranged along the first direction D1 from which the lower pattern BP extends.

The source/drain patterns 150 may also be arranged in the second direction D2. Although not clearly shown in FIG. 1 to FIG. 3, a plurality of lower patterns BP may be arranged to be spaced apart from each other along the second direction D2 on the substrate 10, and the source/drain patterns 150 may be arranged on respective lower patterns BP. Accordingly, the source/drain patterns 150 may be arranged to be spaced apart from each other along the second direction D2 by a distance substantially the same as a distance at which the plurality of lower patterns BP are spaced apart from each other.

The source/drain pattern 150 may be disposed on both sides of the channel layer CH or the sub-gate structure S_GS. Specifically, two source/drain patterns 150 disposed on one lower pattern BP may be arranged to be spaced apart from each other in a direction (for example, the first direction D1) crossing a direction in which the gate structure GS extends, with the channel layer CH or the sub-gate structure S_GS interposed therebetween. The source/drain pattern 150 may directly contact the channel layer CH or the sub-gate structure S_GS. The source/drain pattern 150 may directly contact the sub-gate insulating film 130S of the sub-gate structure S_GS. Although not shown, an inner spacer may be further disposed between the source/drain pattern 150 and the sub-gate insulating film 130S. The inner spacer may include at least one of a silicon nitride (SiN), a silicon oxynitride (SiON), a silicon oxide (SiOx), a silicon carbonate nitride (SiOCN), a silicon boron nitride (SiBN), a silicon oxyboron nitride (SiOBN), a silicon oxycarbide (SiOC), and a combination thereof.

The source/drain pattern 150 may be configured of an epitaxial layer formed by selective epitaxial growth (SEG). In other words, the source/drain patterns 150 may be formed by removing at least a portion of the semiconductor pattern stacked on the lower pattern BP and then using a selective epitaxial growth (SEG) method in the corresponding portion.

The source/drain patterns 150 may include a liner film 150a and a filling film 150b, respectively. The liner film 150a may be disposed outside the filling film 150b. The side and lower surfaces of the filling film 150b may be surrounded by the liner film 150a. The liner film 150a may be in direct contact with the sub-gate structure S_GS and the channel layer CH. The filling film 150b may be disposed on the liner film 150a. The filling film 150b and the liner film 150a may have an upper surface having substantially the same height. However, the present disclosure is not limited thereto, and unlike those in shown FIG. 2, the filling film 150b and the liner film 150a may have upper surfaces having different heights in a partial area.

The source/drain pattern 150 may include a semiconductor material. The source/drain pattern 150 may include, for example, silicon or germanium. In addition, the source/drain pattern 150 may include, for example, a binary compound or a ternary compound containing two or more of carbon (C), silicon (Si), germanium (Ge), and tin (Sn). For example, the source/drain pattern 150 may include silicon, silicon-germanium, germanium, silicon carbide, and the like, but is not limited thereto. In some implementations, the liner film 150a and the filling film 150b may have different silicon (Si) or germanium (Ge) concentrations. For example, the concentration of silicon (Si) or germanium (Ge) included in the liner film 150a may be smaller than that of silicon (Si) or germanium (Ge) included in the filling film 150b.

The semiconductor device may further include an interlayer insulating layer 190 covering the source/drain pattern 150 and the gate structure GS. The interlayer insulating layer 190 may be disposed on the side surface of the gate spacer 142, the side surface of the capping layer 141, and the upper surface of the source/drain patterns 150. The interlayer insulating layer 190 may cover at least a portion of the side surface of the source/drain pattern 150. The interlayer insulating layer 190 may cover the field insulating layer 105. The interlayer insulating layer 190 may not cover an upper surface of the capping layer 141. The interlayer insulating layer 190 may fill the inside of the device isolation trench STI to be described later.

The interlayer insulating layer 190 may include, for example, at least one of a silicon oxide (SiO₂), a silicon nitride (SiN), a silicon oxynitride (SiON), and a low dielectric constant material. The low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ(Tonen SilaZen), FSG (Fluoride silicate glass), polyimide nanofoams such as polypropylene oxide, CDO (Carbon Doped silicon Oxide), OSG (Organo silicate glass), SiLK, Amorphous Fluorinated Carbon, silica aerogels, silica xerogels, mesoporous silica, or a combination thereof, but is not limited thereto. In some implementations, the interlayer insulating layer 190 and the field insulating layer 105 may include different insulating materials. However, the present disclosure is not limited thereto, and in other implementations, the interlayer insulating layer 190 and the field insulating layer 105 may include the same insulating material.

The semiconductor device may further include an upper insulating layer 195 disposed on the interlayer insulating layer 190. The upper insulating layer 195 may be disposed on the upper surface of the capping layer 141 and the upper surface of the interlayer insulating layer 190. The upper insulating layer 195 and the interlayer insulating layer 190 may include the same insulating material. In this case, the interface between the interlayer insulating layer 190 and the upper insulating layer 195 may not be visually recognized. For example, the upper insulating layer 195 may include at least one of a silicon oxide (SiO₂), a silicon nitride (SiN), a silicon oxynitride (SiON), and a low dielectric constant material. In some implementations, the upper insulating layer 195 and the interlayer insulating layer 190 may include different materials.

The insulating pattern 210 may be disposed between two adjacent source/drain patterns 150 below the gate structure GS. The insulating pattern 210 may prevent a leakage current from flowing between two adjacent source/drain patterns 150. The insulating pattern 210 may include a main insulating pattern 212 disposed below the gate structure GS and a sub-insulating pattern 211 disposed between the gate structure GS and the main insulating pattern 212.

The sub-insulating pattern 211 may be disposed below the sub-gate structure S_GS. The sub-insulating pattern 211 may have an upper surface in contact with at least a portion of a lower surface of the lowermost sub-gate structure S_GS among a plurality of sub-gate structures S_GS arranged to be spaced apart from each other in the third direction D3. The upper surface of the sub-insulating pattern 211 may be in contact with at least a portion of the sub-gate insulating film 130S included in the lowermost sub-gate structure S_GS among a plurality of sub-gate structures S_GS arranged spaced apart from each other in the third direction D3. The lower surface of the sub-insulating pattern 211 may be in contact with the lower surface of the main insulating pattern 212. In some implementations, a distance between the upper surface and the lower surface of the sub-insulating pattern 211 may be greater than or equal to about 1 nm, or less than or equal to about 10 nm. That is, a thickness of the sub-insulating pattern 211 in the third direction D3 may range from about 1 nm to about 10 nm.

In some implementations, the maximum width of the sub-insulating pattern 211 in the first direction D1 may be substantially the same as the width of the upper surface of the main insulating pattern 212 in contact with the lower surface of the sub-insulating pattern 211 in the first direction D1. In some implementations, the sub-insulating pattern 211 may have a shape whose width in the horizontal direction (for example, the first direction D1 or the second direction D2) thereof gradually decreases from a lower portion thereof to an upper portion thereof.

A side surface of the sub-insulating pattern 211 may be surrounded by the lower pattern BP and/or the field insulating layer 105. In other words, the sub-insulating pattern 211 may have a side surface that is in contact with the lower pattern BP and/or the field insulating layer 105. For example, in FIG. 2, both side surfaces of the sub-insulating pattern 211 may be in contact with the lower pattern BP. For example, in FIG. 3, both side surfaces of the sub-insulating pattern 211 may be in contact with the field insulating layer 105. When the semiconductor device does not include the lower pattern BP, the sub-insulating pattern 211 may have a side surface in contact with the substrate 10.

A width of the sub-insulating pattern 211 along the first direction D1 may be smaller than a width of the sub-gate structure S_GS along the first direction D1. A width of the sub-insulating pattern 211 along the second direction D2 may be substantially the same as a width of the sub-gate structure S_GS along the second direction D2. However, the present disclosure is not limited thereto, and a width of the sub-insulating pattern 211 along the second direction D2 may be narrower than a width of the sub-gate structure S_GS along the second direction D2.

The sub-insulating pattern 211 may include various insulating materials. The sub-insulating pattern 211 may include at least one of a silicon nitride (SiNₓ), a silicon oxide (SiOₓ), a silicon carbon nitride (SiCₓN_{y}), and a silicon oxynitride (SiOₓN_{y}). In some implementations, the sub-insulating pattern 211 may be formed by a nitridation process. In some implementations, the sub-insulating pattern 211 may include one of a silicon nitride (SiNₓ), a silicon carbon nitride (SiCₓN_{y}), and a silicon oxynitride (SiOₓN_{y}) formed by a nitridation process. In some implementations, the sub-insulating pattern 211 may have different nitrogen concentrations depending on a position thereof. For example, the sub-insulating pattern 211 may have a lower nitrogen concentration as the distance from the interface with the main insulating pattern 212 increases.

The main insulating pattern 212 may be disposed below the sub-insulating pattern 211. The main insulating pattern 212 may penetrate the substrate 10 in the third direction D3. The main insulating pattern 212 may extend into the lower pattern BP. The main insulating pattern 212 may have a shape whose width in the horizontal direction (for example, the first direction D1 or the second direction D2) thereof gradually decreases from a lower portion thereof to an upper portion thereof.

The main insulating pattern 212 may have an upper surface that is in contact with a lower surface of the sub-insulating pattern 211. A lower surface of the main insulating pattern 212 may be in contact with an upper surface of the lower wiring structure 410 to be described later.

A side surface of the main insulating pattern 212 may be surrounded by the lower pattern BP, the substrate 10, and/or the field insulating layer 105. In other words, the main insulating pattern 212 may have a side surface that is in contact with the lower pattern BP, the substrate, and/or the field insulating layer 105. For example, in FIG. 2, both side surfaces of the main insulating pattern 212 may be in contact with the lower pattern BP and the substrate 10. For example, in FIG. 3, both sides of the main insulating pattern 212 may be in contact with the lower pattern BP, the substrate 10, and the field insulating layer 105. When the semiconductor device does not include the lower pattern BP, the main insulating pattern 212 may have a side surface in contact with the substrate 10 and the field insulating layer 105.

The main insulating pattern 212 may include various insulating materials. The main insulating pattern 212 may include one of a silicon nitride (SiNₓ), a silicon oxide (SiOₓ), a silicon carbon nitride (SiCₓN_{y}), and/or a silicon oxynitride (SiOₓN_{y}).

In some implementations, the main insulating pattern 212 and the sub-insulating pattern 211 may include different insulating materials. For example, the sub-insulating pattern 211 may include at least one of a silicon nitride (SiNₓ), a silicon oxide (SiOₓ), a silicon carbon nitride (SiCₓN_{y}), and a silicon oxynitride (SiOₓN_{y}), and the main insulating pattern 212 may include at least one of insulating materials not included in the sub-insulating pattern 211 among a silicon nitride (SiNₓ), a silicon oxide (SiOₓ), a silicon carbonitride (SiCₓN_{y}), and a silicon oxynitride (SiOₓN_{y}). In some implementations, the main insulating pattern 212 and the sub-insulating pattern 211 may include the same insulating material. In this case, the interface between the main insulating pattern 212 and the sub-insulating pattern 211 may not be visually recognized.

In some implementations, the main insulating pattern 212 may be formed by a process different from that of the sub-insulating pattern 211. In other words, the main insulating pattern 212 may include one of a silicon nitride (SiNₓ), a silicon carbon nitride (SiCₓN_{y}), and a silicon oxynitride (SiOₓN_{y}) formed by a process different from that of the sub-insulating pattern 211. For example, the main insulating pattern 212 may be formed by a deposition method such as sputtering, chemical vapor deposition (CVD), or atomic layer deposition (ALD).

The semiconductor device may further include a through electrode 180 disposed on one side of the insulating pattern 210. The through electrode 180 may electrically connect at least one of the source/drain patterns 150 to a lower wiring structure 410 to be described later.

The through electrode 180 may penetrate the substrate 10 and the lower pattern BP in the third direction D3. The through electrode 180 may be recessed into the source/drain pattern 150. Accordingly, the through electrode 180 may be in contact with at least a partial area of the source/drain pattern 150. Referring to FIG. 2, in the area in which the through electrode 180 is recessed into the source/drain pattern 150, the through electrode 180 is shown as being in contact with both the liner film 150a and the filling film 150b of the source/drain pattern 150, but the through electrode 180 may be in contact with only the liner film 150a of the source/drain pattern 150. A silicide film 170 may be disposed between the through electrode 180 and the source/drain pattern 150. The silicide film 170 may extend between the source/drain pattern 150 and the through electrode 180 along at least a portion of the upper surface of the through electrode 180. The silicide film 170 may be a metal silicide film. For example, the silicide film 170 may include at least one of tungsten silicide (WSi), nickel silicide (NiSi), and titanium silicide (TiSi).

The through electrode 180 may also be in contact with the lower pattern BP and/or the substrate 10. Referring to FIG. 2, the through electrode 180 may have a side surface that contacts the lower pattern BP and/or the substrate 10 in an area that does not overlap the source/drain pattern 150 in the horizontal direction. Although not clearly shown in FIG. 2, an insulating pattern may be further disposed along a side profile of the through electrode 180 between the through electrode 180 and the substrate 10, or between the through electrode 180 and the lower pattern BP.

In some implementations, the width of the through electrode 180 in the horizontal direction may gradually become narrower in the direction from the lower surface in contact with the lower wiring structure 410 to be described later toward the source/drain pattern 150.

The through electrode 180 may include at least one of a metal, a metal alloy, a conductive metal nitride, a conductive metal carbide, a conductive metal oxide, a conductive metal carbonitride, and a two-dimensional (2D) material. The metal may include at least one of titanium (Ti), tantalum (Ta), tungsten W, nickel (Ni), cobalt (Co), and platinum (Pt). The conductive metal nitride may include at least one of a titanium nitride (TiN), a tantalum nitride (TaN), a tungsten nitride (WN), a nickel nitride (NiN), a cobalt nitride (CoN), and a platinum nitride (PtN).

The lower wiring structure 410 may be disposed on the lower surface of the substrate 10. The upper surface of the lower wiring structure 410 may partially contact the lower surface of the main insulating pattern 212. The upper surface of the lower wiring structure 410 may partially contact the lower surface of the through electrode 180. The lower wiring structure 410 may include lower conductive patterns 411 and a lower wiring insulating layer 412. The lower conductive patterns 411 may include lower wires arranged spaced apart from each other in third direction D3 and lower wiring vias connecting two lower wires. The lower conductive patterns 411 may be disposed between the lower wiring insulating layers 412. The lower wiring insulating layer 412 may surround the lower conductive patterns 411. That is, the lower wiring insulating layer 412 may cover the lower conductive patterns 411, and the lower conductive patterns 411 may be disposed in the lower wiring insulating layer 412.

The lower conductive patterns 411 may include metal (for example, copper). The lower wiring insulating layer 412 may include at least one of, for example, a silicon oxide (SiO₂), a silicon nitride (SiN), a silicon oxynitride (SiON), and low dielectric films.

In some implementations, an electrical signal or power voltage supplied from the outside may be provided to the source/drain patterns 150 through the lower wiring structure 410 and the through electrode 180 connected thereto.

Although not clearly shown in FIG. 1 to FIG. 3, the semiconductor device may further include an upper wiring structure disposed on the upper insulating layer 195, and contact electrodes disposed between the upper wiring structure and the source/drain pattern 150 or between the upper wiring structure and the main gate structure M_GS. The contact electrodes may penetrate portions of the interlayer insulating layer 190 and the upper insulating layer 195 disposed on at least one of the source/drain patterns 150 to connect the source/drain pattern 150 to the upper wiring structure. The contact electrodes may penetrate at least a portion of the upper insulating layer 195 and the capping layer 141 disposed on the main gate structure M_GS to connect the main gate electrode 120M to the upper wiring structure. When the semiconductor device includes the upper wiring structure and the contact electrodes, at least a portion of an electrical signal or power voltage supplied from the outside may be provided to the source/drain pattern 150 and/or the main gate electrode 120M through the upper wiring structure and the contact electrode.

According to some implementations, the semiconductor device may further include a device isolation trench STI. The semiconductor device may be electrically separated from other adjacent semiconductor devices by the device isolation trench STI. The inner surface of the device isolation trench STI may be defined by the capping layer 141, the gate spacer 142, the lower pattern BP, the substrate 10, and the lower wiring structure 410. The inside of the device isolation trench STI may be filled with the interlayer insulating layer 190.

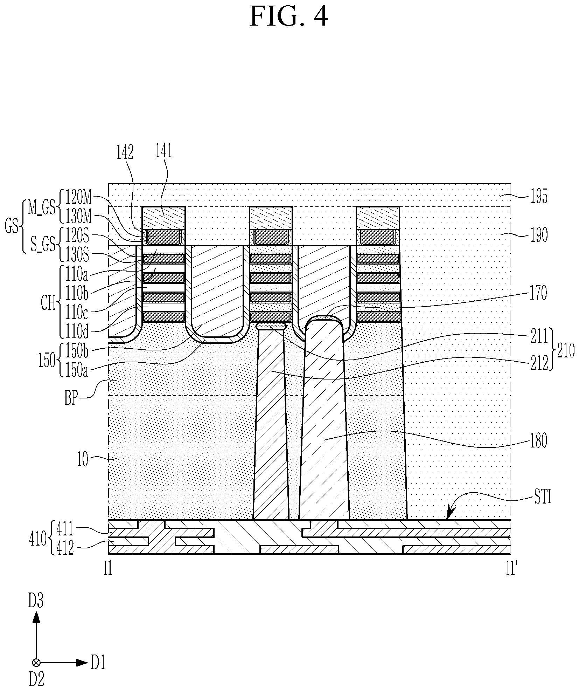

FIG. 4 illustrates an example cross-sectional view of a semiconductor device. Specifically, FIG. 4 illustrates an example cross-sectional view of the semiconductor device taken along line 11-11' of FIG. 1. Since the semiconductor device illustrated in FIG. 4 has many of the same portions as those of the previous implementations, hereinafter, differences from the previous implementations will be mainly described. In the semiconductor device illustrated in FIG. 4, the shape of the sub-insulating pattern 211 disposed between the gate structure GS and the main insulating pattern 212 may be partially different from that of the previous implementations.

Referring to FIG. 4, in the semiconductor device, the width of the sub-insulating pattern 211 along the horizontal direction (for example, the first direction D1 or the second direction D2) may increase and then decrease again as it gets farther from the main insulating pattern 212 toward the lower surface of the gate structure GS. In some implementations, the maximum width of the sub-insulating pattern 211 along the first or second direction D1 or D2 may be disposed between the upper surface of the main insulating pattern 212 and the lower surface of the gate structure GS. Unlike shown in FIG. 4, in the semiconductor device, the width of the sub-insulating pattern 211 along the horizontal direction (for example, the first direction D1 or the second direction D2) may increase and then decrease again as it gets farther from the main insulating pattern 212 toward the lower surface of the gate structure GS. In this case, the sub-insulating pattern 211 may have a maximum width along the first direction D1 or the second direction D2 on a surface contacting the lower surface of the gate structure GS.

The nitrogen concentration of the sub-insulating pattern 211 may gradually decrease as the distance from the interface with the main insulating pattern 212 increases.

In some implementations, the sub-insulating pattern 211 may be formed by a plasma nitridation process. In the plasma nitridation process, the sub-insulating pattern 211 may be formed as nitrogen (N) diffuses from the upper surface of the main insulating pattern 212 into the lower pattern BP disposed below the gate structure GS. Accordingly, as illustrated in FIG. 4, the maximum width of the sub-insulating pattern 211 in the horizontal direction may be wider than the width of the upper surface of the main insulating pattern 212 in the horizontal direction.

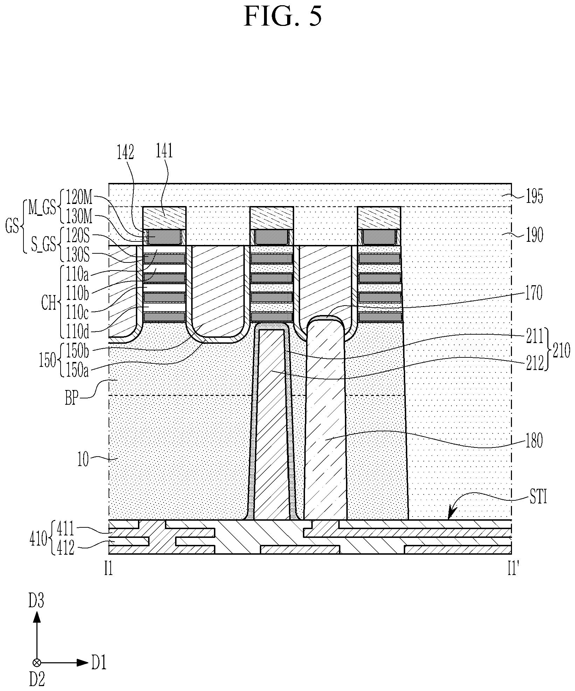

FIG. 5 illustrates an example cross-sectional view of a semiconductor device. Specifically, FIG. 5 illustrates an example cross-sectional view of the semiconductor device taken along line 11-11' of FIG. 1. Since the semiconductor device illustrated in FIG. 5 has many of the same portions as those of the previous implementations, hereinafter, differences from the previous implementations will be mainly described. In the semiconductor device illustrated in FIG. 5, the location at which the sub-insulating pattern 211 is formed may be partially different from the previous implementations.

Referring to FIG. 5, in the semiconductor device, the sub-insulating pattern 211 may be disposed between the substrate 10 and the main insulating pattern 212 and/or between the lower pattern BP and the main insulating pattern 212. The sub-insulating pattern 211 may be disposed on the side surface or the upper surface of the main insulating pattern 212. The sub-insulating pattern 211 may be disposed along the profile of the side surface and the upper surface of the main insulating pattern 212. In some implementations, the nitrogen concentration of the sub-insulating pattern 211 may gradually decrease as the distance from the interface with the main insulating pattern 212 increases.

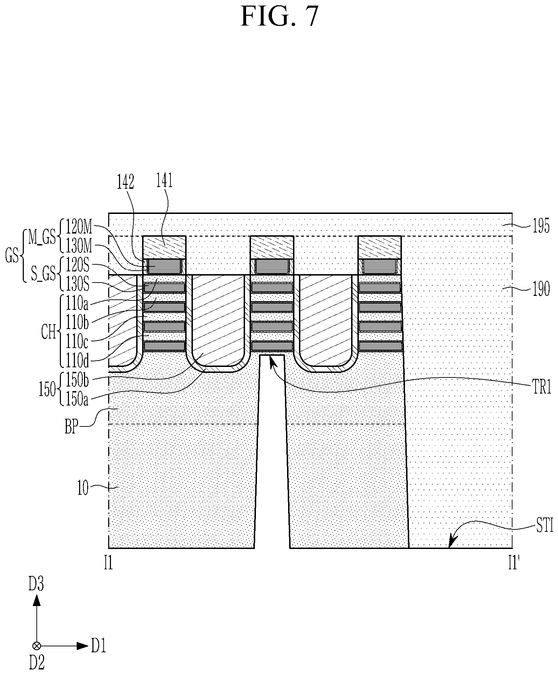

In some implementations, the sub-insulating pattern 211 may be formed by a thermal nitridation process. In the thermal nitridation process, the sub-insulating pattern 211 may be formed as nitrogen (N) diffuses from the inner wall and bottom surface of a first trench TR1 (see FIG. 7) formed below the gate structure GS into the substrate 10 and/or the lower pattern BP. Accordingly, as shown in FIG. 5, the sub-insulating pattern 211 may be disposed not only between the upper surface of the main insulating pattern 212 and the lower surface of the gate structure GS, but also between the substrate 10 and the main insulating pattern 212 and/or between the lower pattern BP and the main insulating pattern 212.

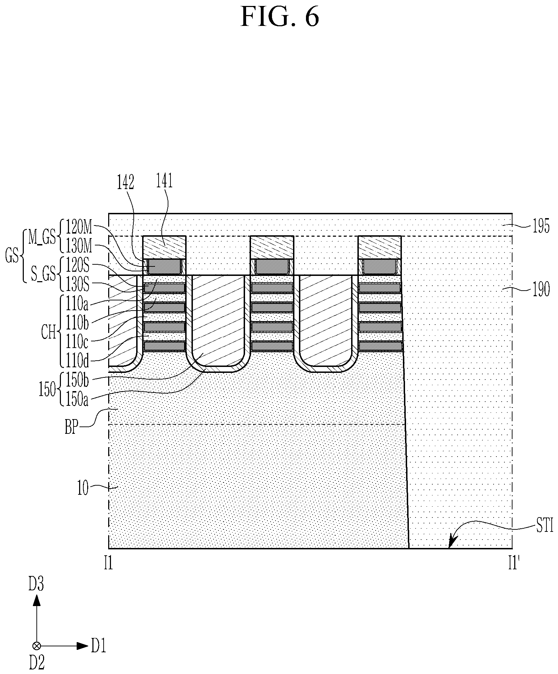

FIG. 6 to FIG. 14 are drawings for explaining an example of a manufacturing method of a semiconductor device.

As shown in FIG. 6, the lower pattern BP, the channel layers CH, the gate structures GS surrounding the channel layers CH, and the source/drain patterns 150 connected to both sides of respective channel layers CH may be formed on the substrate 10. The device isolation trench STI may be formed by recessing the lower pattern BP and a portion of the substrate 10. The interlayer insulating layer 190 and/or the upper insulating layer 195 may cover the channel layers CH, the gate structures GS, and the source/drain patterns 150. The interlayer insulating layer 190 may fill the inside of the device isolation trench STI.

In some implementations, the substrate 10 may be a silicon-on-insulator (SOI) or bulk silicon. Alternatively, the substrate 10 may be a silicon substrate, or may include other materials, such as a silicon germanium (SiGe), a silicon germanium on insulator (SGOI), an indium antimonide, a lead telluride, an indium arsenide, an indium phosphide, a gallium arsenide, or a gallium antimonide, but the present disclosure is not limited thereto. The lower pattern BP may be a portion of the substrate 10 or may be grown from the substrate 10 through an epitaxial growth method.

As shown in FIG. 7, a first trench TR1 penetrating the substrate 10 in the third direction D3 may be formed below the gate structure GS. The first trench TR1 may be formed by etching at least a portion of the substrate 10 and the lower pattern BP.

The first trench TR1 may penetrate the substrate 10 in the third direction D3 and extend into the lower pattern BP. The first trench TR1 may be disposed adjacent to the lower surface of the gate structure GS. The first trench TR1 may not be in contact with the lower surface of the gate structure GS. In other words, the bottom surface of the first trench TR1 may be spaced apart from the bottom surface of the gate structure GS. Referring to FIG. 7, the bottom surface of the first trench TR1 extends from the inner surface of the first trench TR1, and may mean a surface adjacent to the lower surface of the gate structure GS. The lower pattern BP may be disposed between the bottom surface of the first trench TR1 and the lower surface of the gate structure GS. The first trench TR1 may have a shape whose width in the horizontal direction becomes gradually narrower as it gets closer toward the lower surface of the gate structure GS.

In some implementations, the first trench TR1 may be formed by a dry etching process. For example, the process of forming the first trench TR1 may be performed by reactive ion etching (RIE) or inductively coupled plasma (ICP). However, the present disclosure is not limited thereto, and the first trench TR1 may be formed by a wet etching process.

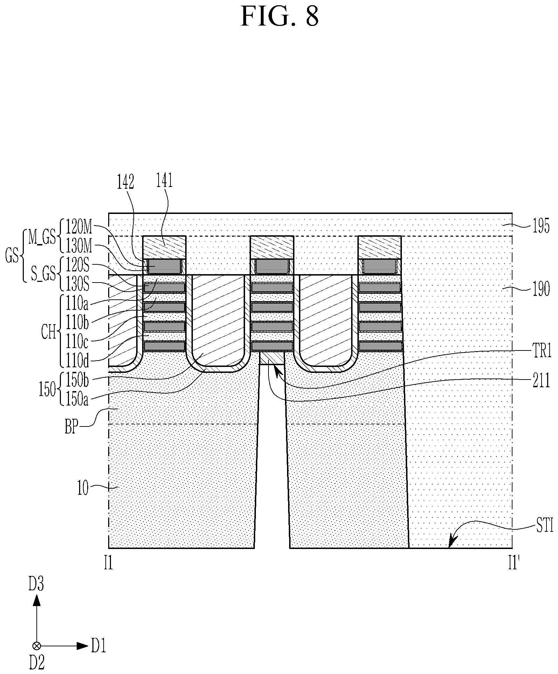

As shown in FIG. 8, the sub-insulating pattern 211 may be formed between the first trench TR1 and the lower surface of the gate structure GS.

In some implementations, the sub-insulating pattern 211 may include nitrogen. For example, the sub-insulating pattern 211 may include at least one of a silicon nitride (SiNₓ), a silicon carbon nitride (SiCₓN_{y}), and a silicon oxynitride (SiOₓN_{y}).

In some implementations, the sub-insulating pattern 211 may be formed by a nitridation process. For example, the sub-insulating pattern 211 may be formed by a thermal or plasma nitridation process. The sub-insulating pattern 211 may be formed by injecting one or more source materials containing nitrogen into a chamber having predetermined temperature and pressure conditions. For example, the source material may include at least one of N₂, NH₃, NH₄, and NO. In some implementations, plasma may be formed inside the chamber. For example, in order to form plasma inside the chamber, power may be supplied between two electrodes disposed in the chamber. In this case, the supplied power may be DC power or radio frequency (RF) power.

The sub-insulating pattern 211 may be formed only in a partial area of the lower pattern BP. For example, referring to FIG. 8, the sub-insulating pattern 211 may be formed by nitriding the lower pattern BP disposed between the lower surface of the gate structure GS and the bottom surface of the first trench TR1. In order to allow the sub-insulating pattern 211 to be formed only in a partial area of the lower pattern BP, at least one or more process variables during the nitridation process may be controlled. For example, an electrical bias applied between two electrodes disposed inside the chamber to generate plasma may be controlled.

In some implementations, as the lower pattern BP is nitrided to be changed into the sub-insulating pattern 211, the thickness thereof may increase. In other words, referring to FIG. 7 and FIG. 8 together, the distance between the upper and lower surfaces of the sub-insulating pattern 211 may be longer than the distance between the lower surface of the gate structure GS and the bottom surface of the first trench TR1 before the sub-insulating pattern 211 is formed.

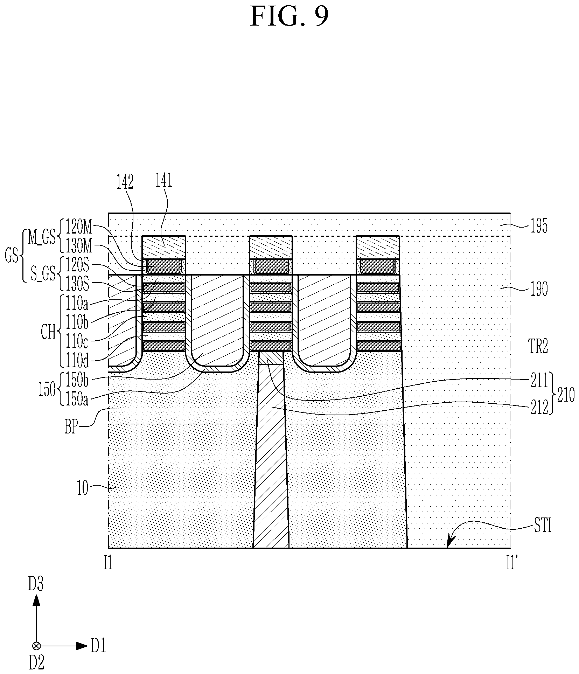

As shown in FIG. 9, the main insulating pattern 212 filling the inside of the first trench TR1 may be formed. In some implementations, the main insulating pattern 212 may be formed by depositing an insulating material inside the first trench TR1 and on the lower surface of the substrate 10, and then removing the insulating material deposited on the lower surface of the substrate 10. In some implementations, the process of removing the insulating material deposited on the lower surface of the substrate 10 may be performed by a chemical mechanical polishing (CMP) process. In some implementations, the main insulating pattern 212 may be formed by a deposition method such as sputtering, chemical vapor deposition (CVD), or atomic layer deposition (ALD).

In some implementations, the main insulating pattern 212 and the sub-insulating pattern 211 may include different insulating materials. For example, the sub-insulating pattern 211 may include at least one of a silicon nitride (SiNₓ), a silicon oxide (SiOₓ), a silicon carbon nitride (SiCₓN_{y}), and a silicon oxynitride (SiOₓN_{y}), and the main insulating pattern 212 may include at least one of insulating materials not included in the sub-insulating pattern 211 among a silicon nitride (SiNₓ), a silicon oxide (SiOₓ), a silicon carbonitride (SiCₓN_{y}), and a silicon oxynitride (SiOₓN_{y}). In some implementations, the main insulating pattern 212 and the sub-insulating pattern 211 may include the same insulating material. In this case, the interface between the main insulating pattern 212 and the sub-insulating pattern 211 may not be visually recognized.

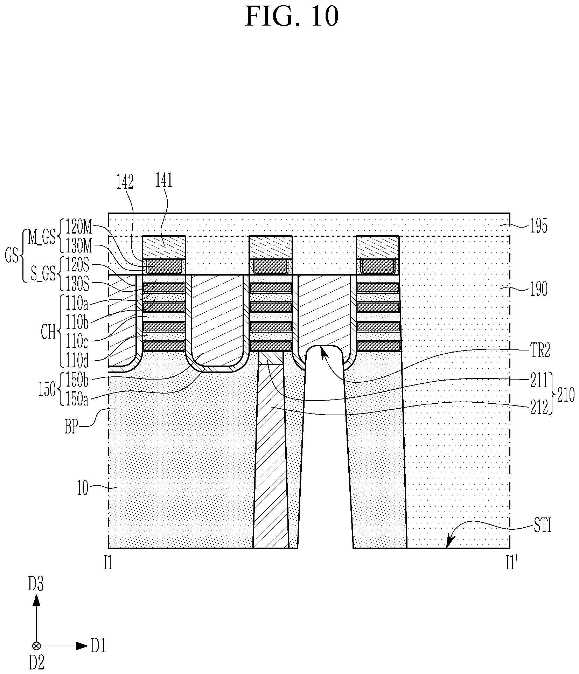

As shown in FIG. 10, a second trench TR2 penetrating the substrate 10 in the third direction D3 may be formed below the source/drain pattern 150. The second trench TR2 may be formed by etching at least a portion of the substrate 10 and the lower pattern BP. The second trench TR2 may penetrate the substrate 10 and the lower pattern BP in the third direction D3 to extend into the inside of the source/drain pattern 150. The side surface of the second trench TR2 may be defined by the substrate 10, the lower pattern BP, and the source/drain pattern 150. The lower surface of the second trench TR2 may be defined by the source/drain pattern 150.

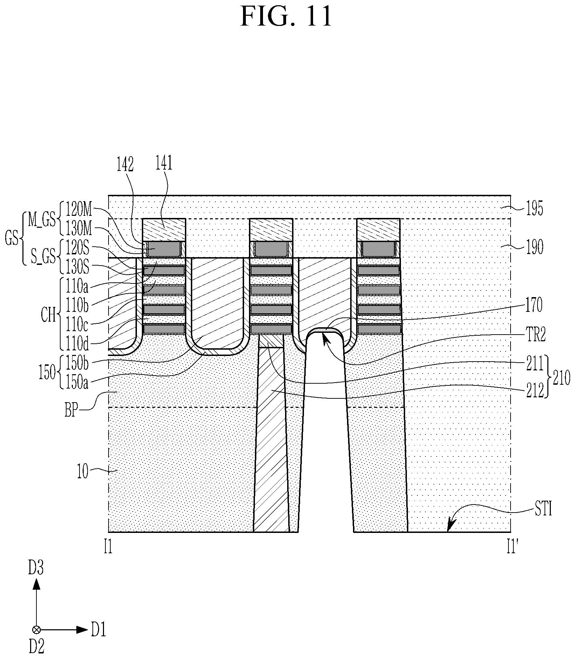

As shown in FIG. 11, the silicide film 170 may be partially formed on the bottom surface and the side surface of the second trench TR2. The silicide film 170 may be conformally formed on the bottom surface and a portion of the side surface of the second trench TR2. The silicide film 170 may be formed on the bottom surface of the second trench TR2 and an area in contact with the source/drain pattern 150 among the entire area of the side surface of the second trench TR2. However, the present disclosure is not limited thereto, and the silicide film 170 may be formed on the entire areas of the bottom surface and the side surface of the second trench TR2.

In some implementations, the silicide film 170 may be deposited by a deposition method such as physical vapor deposition (PVD) or chemical vapor deposition (CVD), or may be formed by depositing a metal on the second trench TR2 and then performing an annealing process. For example, the silicide film 170 may include at least one of tungsten silicide (WSi), nickel silicide (NiSi), and/or titanium silicide (TiSi).

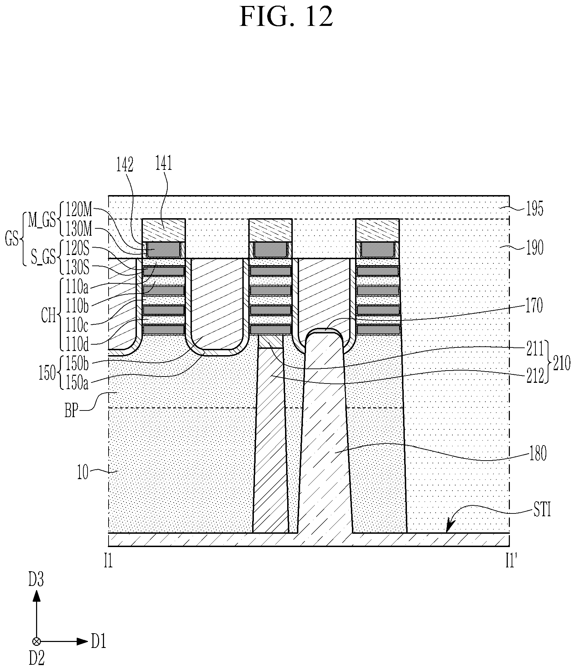

As shown in FIG. 12, the through electrode 180 may be formed inside the second trench TR2 and on the lower surface of the substrate 10. In some implementations, the through electrode 180 may include a conductive material. The through electrode 180 may include, for example, at least one of a metal, a metal alloy, a conductive metal nitride, a conductive metal carbide, a conductive metal oxide, a conductive metal carbonitride, and a two-dimensional (2D) material. The metal may include at least one of titanium (Ti), tantalum (Ta), tungsten W, nickel (Ni), cobalt (Co), and platinum (Pt). The conductive metal nitride may include at least one of a titanium nitride (TiN), a tantalum nitride (TaN), a tungsten nitride (WN), a nickel nitride (NiN), a cobalt nitride (CoN), and a platinum nitride (PtN).

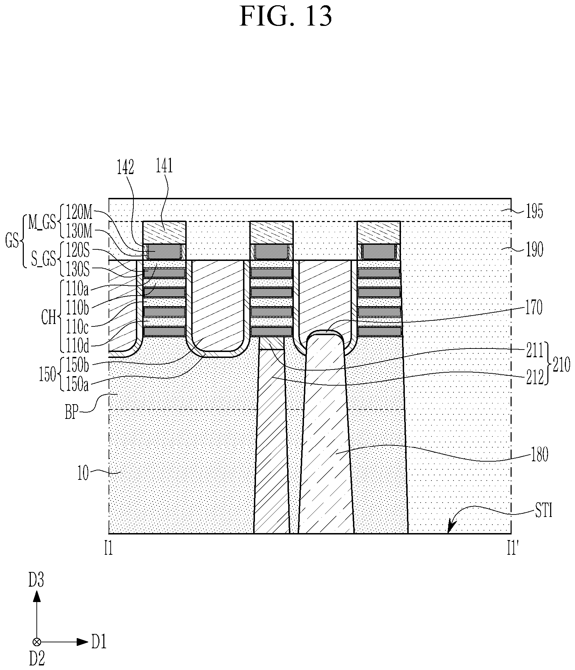

Subsequently, as shown in FIG. 13, a partial area of the through electrode 180 formed on the same plane as the surface including the lower surface of the substrate 10 may be removed, e.g. by a chemical mechanical polishing (CMP) process.

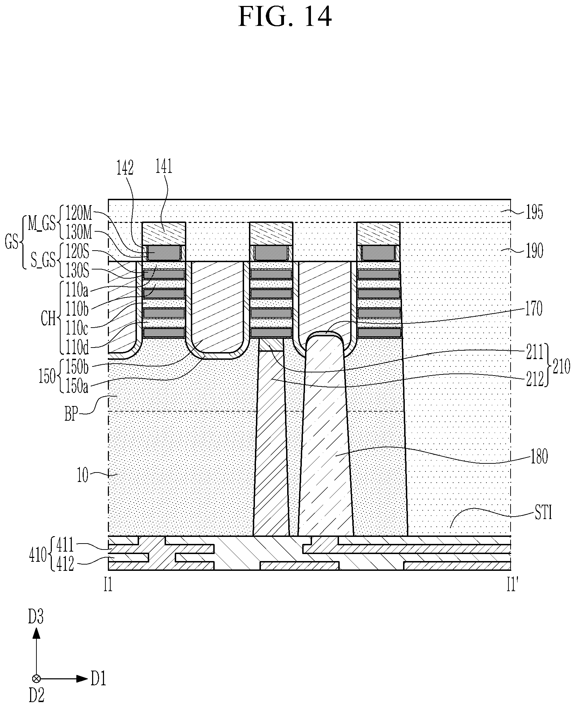

As shown in FIG. 14, the lower wiring structure 410 electrically connected to the through electrode 180 may be formed on the lower surface of the substrate 10.

The lower wiring structure 410 may include the lower conductive patterns 411 and the lower wiring insulating layer 412. The lower conductive patterns 411 may include lower wires arranged spaced apart from each other in third direction D3 and lower wiring vias connecting two lower wires. The lower conductive patterns 411 may be disposed between the lower wiring insulating layers 412. The lower wiring insulating layer 412 may surround the lower conductive patterns 411. That is, the lower wiring insulating layer 412 may cover the lower conductive patterns 411, and the lower conductive patterns 411 may be disposed in the lower wiring insulating layer 412. The lower conductive patterns 411 may include metal (for example, copper). The lower wiring insulating layer 412 may include at least one of, for example, a silicon oxide (SiO₂), a silicon nitride (SiN), a silicon oxynitride (SiON), and low dielectric films.

In the manufacturing process of the semiconductor device, in order to form the insulating pattern 210, only a portion of the lower pattern BP disposed under the gate structure GS may be etched without being completely etched. Thereafter, a partial area of the lower pattern BP disposed between the gate structure GS and the first trench TR1 may be nitrided to form the sub-insulating pattern 211. In the process of etching the substrate 10 and the lower pattern BP to form the insulating pattern 210, the insulating layers (for example, the sub-gate insulating film 130S) included in the gate structure GS may not be damaged by the etching material, thereby improving the reliability of the semiconductor device.

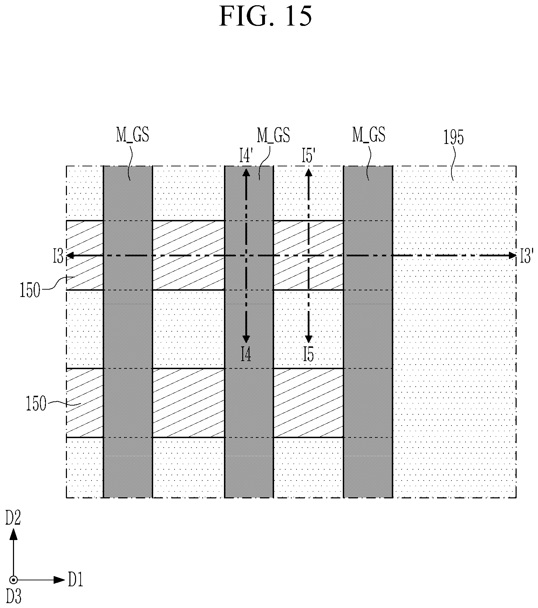

FIG. 15 to FIG. 18 are drawings for explaining a semiconductor device. Since the semiconductor device illustrated in FIG. 15 to FIG. 18 has many of the same portions as the semiconductor device described with reference to FIG. 1 to FIG. 5, differences from the previous implementations will be mainly described hereinafter. The semiconductor device may be partially different from the previous implementations in that it includes the insulating liner 220 disposed on the side surface of the through electrode 180.

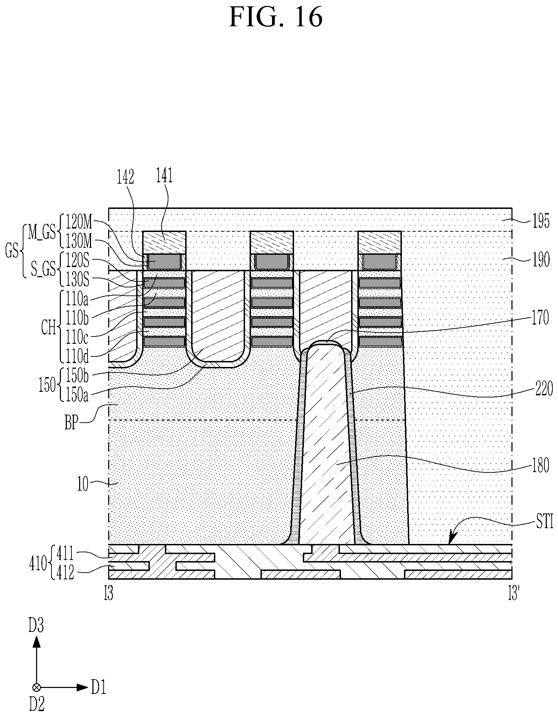

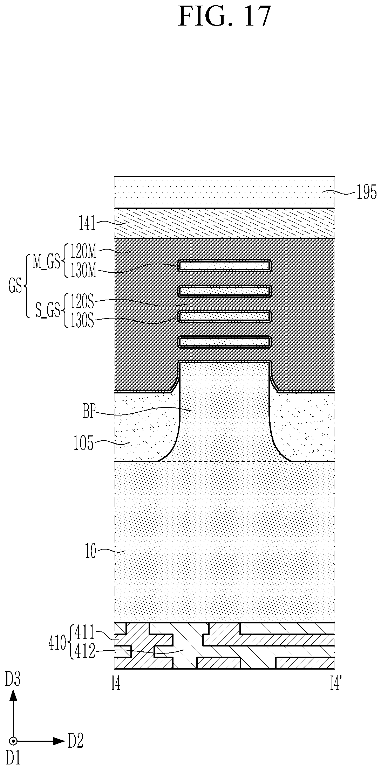

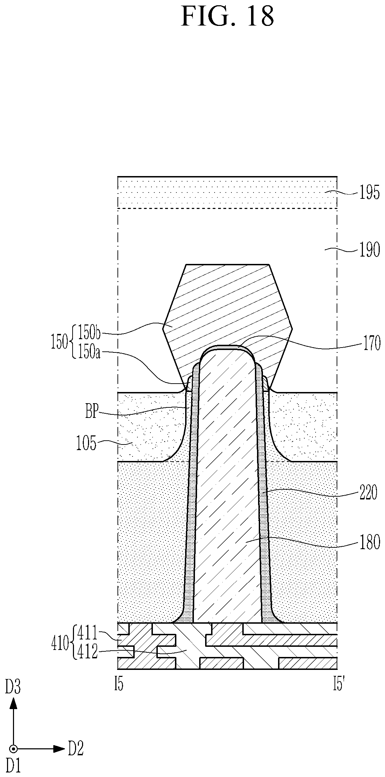

FIG. 15 illustrates a top plan view of an example of a semiconductor device. FIG. 16 to FIG. 18 illustrate example cross-sectional views of a semiconductor device. Specifically, FIG. 16 illustrates an example cross-sectional view of the semiconductor device taken along line I3-I3' of FIG. 15, FIG. 17 illustrates an example cross-sectional view of the semiconductor device taken along line I4-I4' of FIG. 15, and FIG. 18 illustrates an example cross-sectional view of the semiconductor device taken along line I5-I5' of FIG. 15.

Referring to FIG. 15 to FIG. 18, the semiconductor device may include the lower pattern BP, the channel layers CH disposed on the lower pattern BP, the gate structure GS surrounding the channel layers CH, the source/drain patterns 150 disposed on both sides of each channel layer CH, the lower wiring structure 410 disposed below the lower pattern BP, the through electrode 180 disposed between the source/drain pattern 150 and the lower wiring structure 410, and the insulating liner 220 disposed on the side surface of the through electrode 180.

The semiconductor device may further include the substrate 10 disposed below the lower pattern BP, the gate spacer 142 disposed on the side surface of the main gate electrode 120M, the capping layer 141 disposed on the main gate structure M_GS, the interlayer insulating layer 190 covering the source/drain pattern 150 and the gate structure GS, and the upper insulating layer 195 disposed on the interlayer insulating layer 190.

The semiconductor device may not include the insulating pattern 210 described with reference to FIG. 1 to FIG. 5. In the semiconductor device, the substrate 10, the lower pattern BP, the channel layers CH, the gate structure GS, the source/drain patterns 150, the lower wiring structure 410, the through electrode 180, the gate spacer 142, the capping layer 141, the interlayer insulating layer 190, and the upper insulating layer 195 are the same as those described with reference to FIG. 1 to FIG. 5, so detailed descriptions thereof will be omitted.

The insulating liner 220 may be disposed on the side surface of the through electrode 180. Specifically, the insulating liner 220 may be disposed between the through electrode 180 and the substrate 10, between the through electrode 180 and the lower pattern BP, and between the through electrode 180 and the source/drain pattern 150. When an electrical signal is applied from the lower wiring structure 410 to the source/drain pattern 150 through the through electrode 180, the insulating liner 220 may prevent a current from leaking to another source/drain pattern 150 that is not connected to the through electrode 180.

Referring to FIG. 16 and FIG. 18, the insulating liner 220 may extend from the upper surface of the lower wiring structure 410 toward the source/drain pattern 150. The insulating liner 220 may penetrate the substrate 10 and the lower pattern BP. The insulating liner 220 may be recessed into the source/drain pattern 150. In some implementations, a width of the insulating liner 220 along the horizontal direction may be greater than or equal to about 1 nm and less than or equal to about 10 nm.

The insulating liner 220 may have an inner surface in contact with the through electrode 180, and an outer surface in contact with the substrate 10, the lower pattern BP, and the source/drain pattern 150. The insulating liner 220 may have a rounded upper surface. The width of the insulating liner 220 in the horizontal direction may gradually increase from an area adjacent to the upper surface of the lower wiring structure 410 toward the upper surface of the lower wiring structure 410.

The insulating liner 220 may include various insulating materials. The insulating liner 220 may include at least one of a silicon nitride (SiNₓ), a silicon oxide (SiOₓ), a silicon carbon nitride (SiCₓN_{y}), and a silicon oxynitride (SiOₓN_{y}). In some implementations, the insulating liner 220 may be formed by a nitridation process. In some implementations, the insulating liner 220 may include one of a silicon nitride (SiNₓ), a silicon carbon nitride (SiCₓN_{y}), and a silicon oxynitride (SiOₓN_{y}) formed by a nitridation process. In some implementations, the insulating liner 220 may have different nitrogen concentrations depending on a position thereof. For example, the insulating liner 220 may have a lower nitrogen concentration as it gets farther from the interface with the through electrode 180. In some implementations, the insulating liner 220 may be formed by a thermal nitridation process. However, it is not limited thereto, the insulating liner 220 may be formed by a plasma nitridation process. In the nitridation process, the insulating liner 220 may be formed by diffusing into the lower pattern BP, the substrate 10, or the source/drain pattern 150 from a surface in contact with the through electrode 180.

The silicide film 170 may be disposed between the upper surface of the through electrode 180 and the source/drain pattern 150. The silicide film 170 may be disposed along the profile of the upper surface of the through electrode 180. The silicide film 170 may not be disposed on the side surface of the through electrode 180. In some implementations, the silicide film 170 may not overlap the insulating liner 220 in the horizontal direction.

According to some implementations, the insulating liner 220 for preventing a leakage path from the through electrode 180 to the substrate 10 or to the source/drain pattern 150 through the inside of the lower pattern BP may be formed by a nitridation process. In this case, compared to the case in which the insulating liner 220 is formed by a deposition method such as physical vapor deposition (PVD) or chemical vapor deposition (CVD), more space in which the through electrode 180 is formed may be secured, thereby improving the electrical characteristics of the semiconductor device.

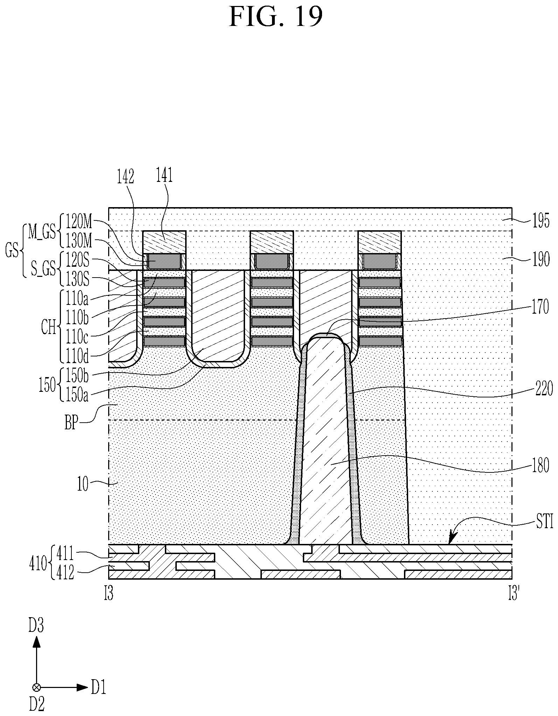

FIG. 19 illustrates an example cross-sectional view of a semiconductor device. Specifically, FIG. 19 illustrates an example cross-sectional view of the semiconductor device taken along line I3-I3' of FIG. 15. Since the semiconductor device illustrated in FIG. 19 has many of the same portions as those of the previous implementations, hereinafter, differences from the previous implementations will be mainly described. The semiconductor device illustrated in FIG. 19 may have a width in the horizontal direction of the insulating liner 220 that is partially different from that of the previous implementations. Referring to FIG. 19, the width in the horizontal direction of the insulating liner 220 disposed between the side surface of the through electrode 180 and the source/drain pattern 150 may be narrower than the width in the horizontal direction of the insulating liner 220 disposed between the side surface of the through electrode 180 and the lower pattern BP.

Referring to FIG. 19, the width of the insulating liner 220 in the horizontal direction may be narrower between the through electrode 180 and the source/drain pattern 150 than between the through electrode 180 and the substrate 10 or between the through electrode 180 and the lower pattern BP. In some implementations, the insulating liner 220 may be formed by a nitridation process, and the nitridation rate may vary depending on the nitrided material. For example, in some implementations, the nitridation rate may be slower in the source/drain pattern 150 than in the substrate 10 and the lower pattern BP. Accordingly, the width of the insulating liner 220 in the horizontal direction may be formed narrower between the side surface of the through electrode 180 and the source/drain pattern 150 than between the side surface of the through electrode 180 and the lower pattern BP.

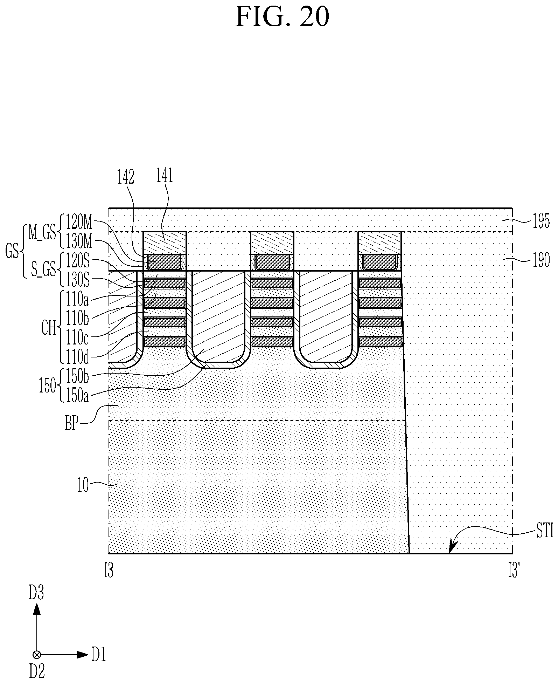

FIG. 20 to FIG. 28 are drawings for describing an example of the method of manufacturing the semiconductor device described with reference to FIG. 15 to FIG. 18.

As shown in FIG. 20, the lower pattern BP, the channel layers CH, the gate structures GS surrounding the channel layers CH, and the source/drain patterns 150 connected to both sides of respective channel layers CH may be formed on the substrate 10. The device isolation trench STI may be formed by recessing the lower pattern BP and a portion of the substrate 10. The interlayer insulating layer 190 and/or the upper insulating layer 195 may cover the channel layers CH, the gate structures GS, and the source/drain patterns 150. The interlayer insulating layer 190 may fill the inside of the device isolation trench STI.

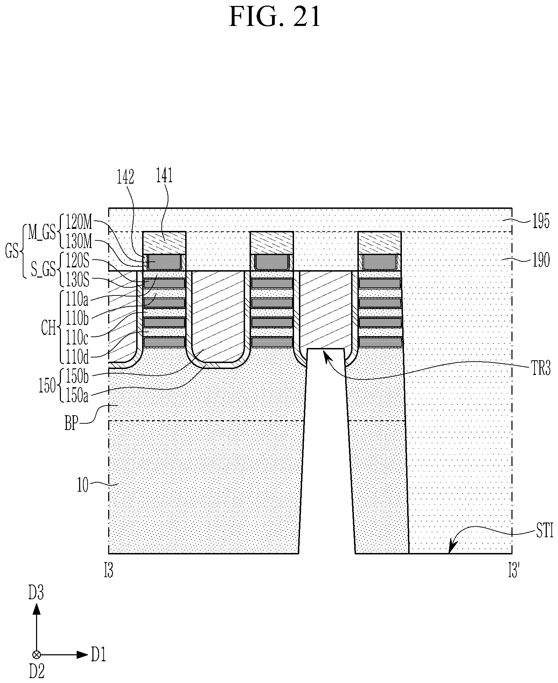

As shown in FIG. 21, a third trench TR3 penetrating the substrate 10 and the lower pattern BP in the third direction D3 may be formed below the source/drain pattern 150. The third trench TR3 may penetrate the substrate 10 and the lower pattern BP in the third direction D3 to be recessed into the inside of the source/drain pattern 150. The third trench TR3 may be formed by at least partially etching the substrate 10, the lower pattern BP, and the source/drain pattern 150. The side surface of the third trench TR3 may be defined by the substrate 10, the lower pattern BP, and the source/drain pattern 150. The bottom surface of the third trench TR3 may be defined by the source/drain pattern 150.

In some implementations, the third trench TR3 may be formed by a dry etching process. For example, the process of forming the third trench TR3 may be performed by reactive ion etching (RIE) or inductively coupled plasma (ICP). However, the present disclosure is not limited thereto, and the third trench TR3 may be formed by a wet etching process.

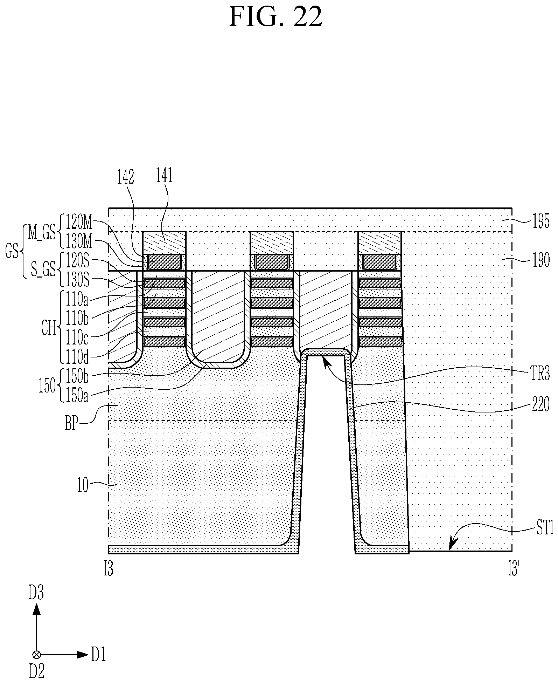

As shown in FIG. 22, the insulating liner 220 may be formed on the side surface and the bottom surface of the third trench TR3. The insulating liner 220 may also be formed on the lower surface of the substrate 10. The insulating liner 220 may not be disposed on the lower surface of the interlayer insulating layer 190 filling the inside of the device isolation trench STI. In some implementations, the insulating liner 220 may be formed by diffusing from the side surface and the bottom surface of the third trench TR3 into the lower pattern BP, the substrate 10, and the source/drain pattern 150. The insulating liner 220 disposed on the lower surface of the substrate 10 may be formed by diffusing from the lower surface of the substrate 10 into the inside of the substrate 10.

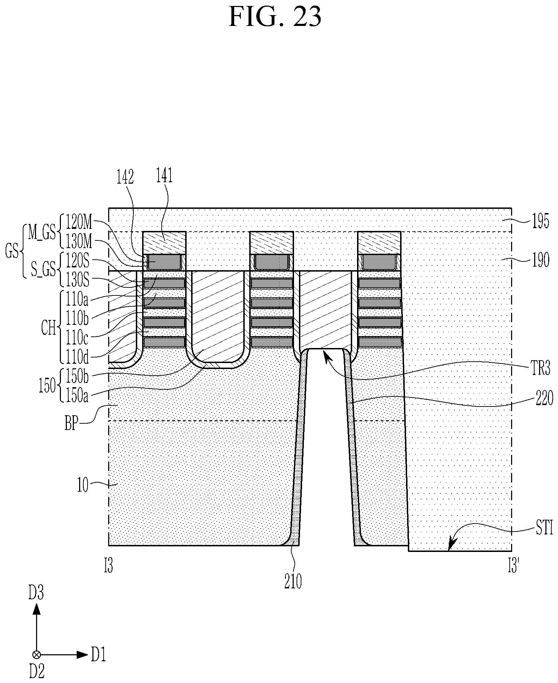

In some implementations, the insulating liner 220 may be formed by growing from the side surface and the bottom surface of the third trench TR3 toward the inside of the third trench TR3. Accordingly, referring to FIG. 22 and FIG. 23, the width in the horizontal direction of the third trench TR3 after the insulating liner 220 is formed may be narrower than the width in the horizontal direction of the third trench TR3 before the insulating liner 220 is formed. In addition, the depth in the vertical direction of the third trench TR3 after the insulating liner 220 is formed may be shallower than the depth in the vertical direction of the third trench TR3 before the insulating liner 220 is formed.

As shown in FIG. 23, a partial area of the insulating liner 220 disposed between the bottom surface of the third trench TR3 and the source/drain pattern 150 may be removed to expose a partial area of the source/drain pattern 150. In this case, a partial area of the insulating liner 220 disposed on the lower surface of the substrate 10 may be removed together. The process of removing the partial area of the insulating liner 220 may be performed by an anisotropic etching process. For example, a partial area of the insulating liner 220 may be removed by a dry etching process using reactive ion etching (RIE) or inductively coupled plasma (ICP). However, the present disclosure is not limited thereto, and the insulating liner 220 may be removed by a wet etching process.

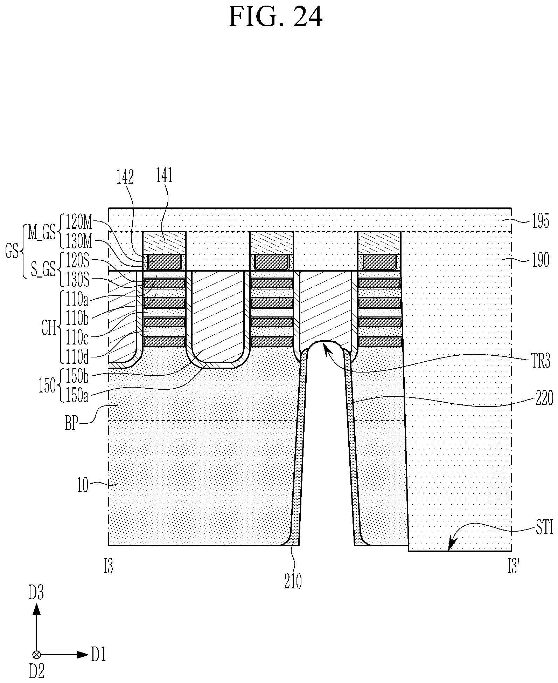

As shown in FIG. 24, a partial area of the source/drain pattern 150 exposed on the bottom surface of the third trench TR3 may be etched.

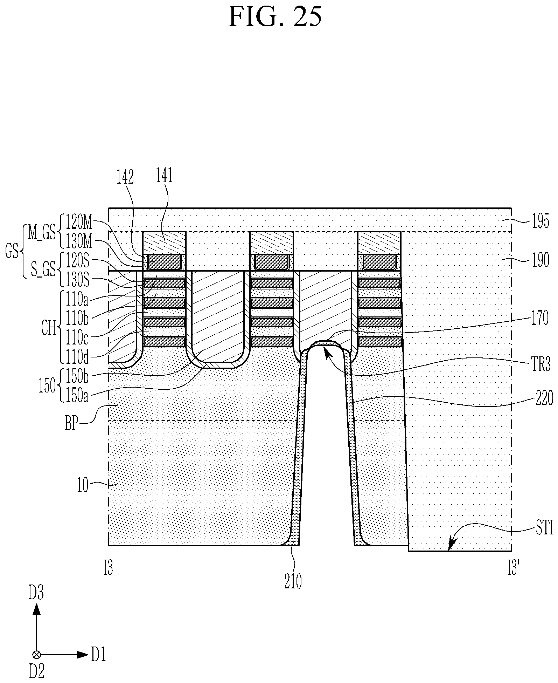

Subsequently, as shown in FIG. 25, the silicide film 170 may be formed on the bottom surface of the third trench TR3. The silicide film 170 may not be formed on the side surface of the third trench TR3. The silicide film 170 may be formed along the lower surface of the source/drain pattern 150 exposed on the bottom surface of the third trench TR3. The silicide film 170 may be formed, for example, by depositing a metal material on the side surface and the bottom surface of the third trench TR3 and then performing annealing. The silicide film 170 may be formed at an interface where the source/drain pattern 150 and the metallic material are in contact with each other. The silicide film 170 may not be formed at an interface where the insulating liner 220 and the metallic material are in contact with each other. After the silicide film 170 is formed, the metal material deposited on the side surface and the bottom surface of the third trench TR3 may be removed.

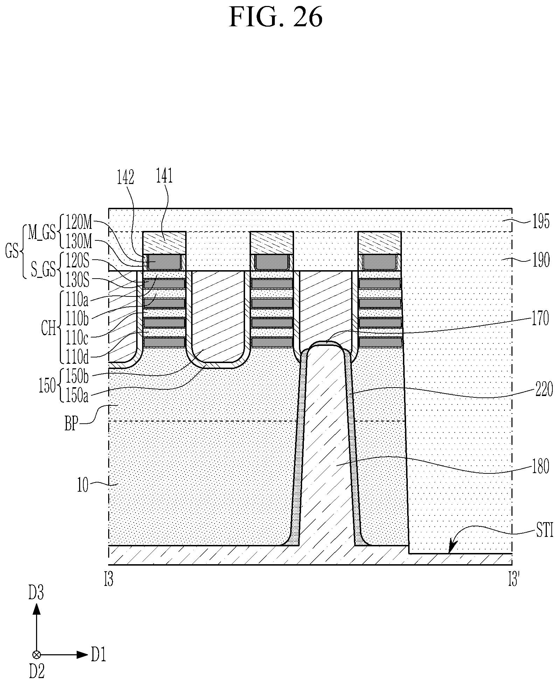

As shown in FIG. 26, the inside of the third trench TR3 may be filled with a conductive material to form the through electrode 180. In FIG. 26, the through electrode 180 may be formed on the lower surface of the substrate 10 and also on the lower surface of the interlayer insulating layer 190 filling the device isolation trench STI.

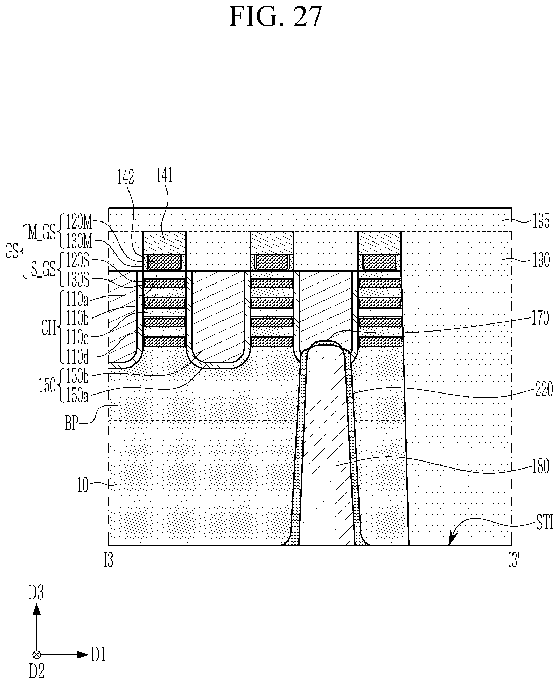

Subsequently, as shown in FIG. 27, a partial area of the through electrode 180 formed on the same plane as the surface including the lower surface of the substrate 10 may be removed, e.g. by a chemical mechanical polishing (CMP) process. In this case, a partial area of the interlayer insulating layer 190 that fills the inside of the device isolation trench STI may also be removed.

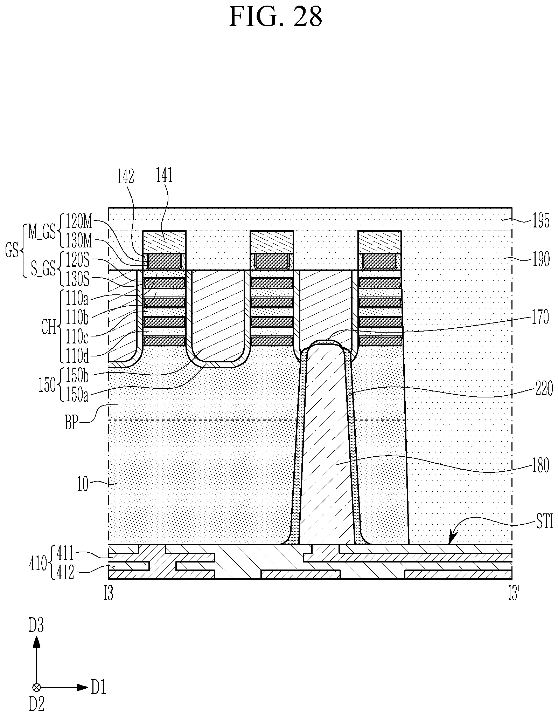

As shown in FIG. 28, the semiconductor device described with reference to FIG. 15 to FIG. 18 may be manufactured by forming the lower wiring structure 410 electrically connected to the through electrode 180 on the lower surface of the substrate 10.

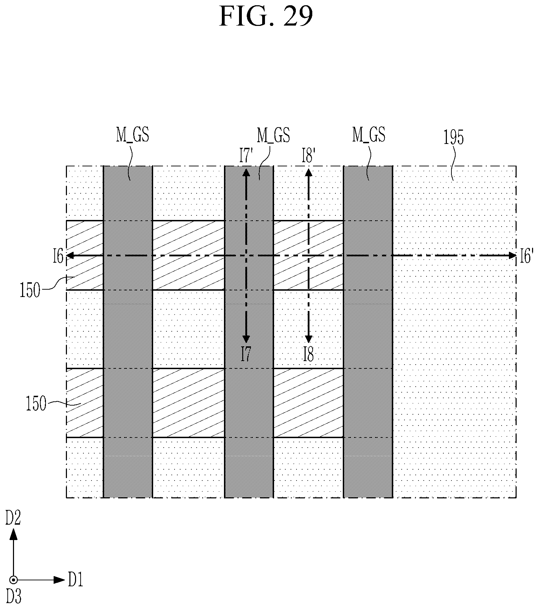

FIG. 29 to FIG. 32 are drawings for explaining a semiconductor device. Since the semiconductor device shown in FIG. 29 to FIG. 32 is substantially the same as the semiconductor device according to the previous implementations, hereinafter, differences from the previous implementations will be mainly described. The semiconductor device may be partially different from the previous implementations in that the semiconductor device includes the lower conductive layer 185 between the lower surface of the lower pattern BP and the lower wiring structure 410, and the insulating liner 220 is also disposed between the lower conductive layer 185 and the lower pattern BP.

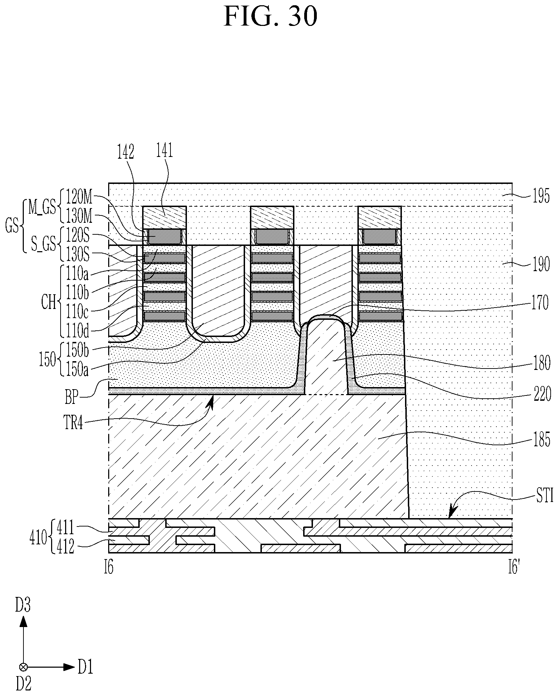

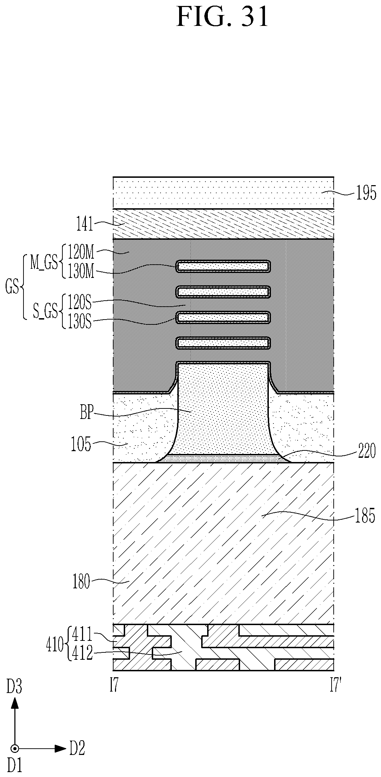

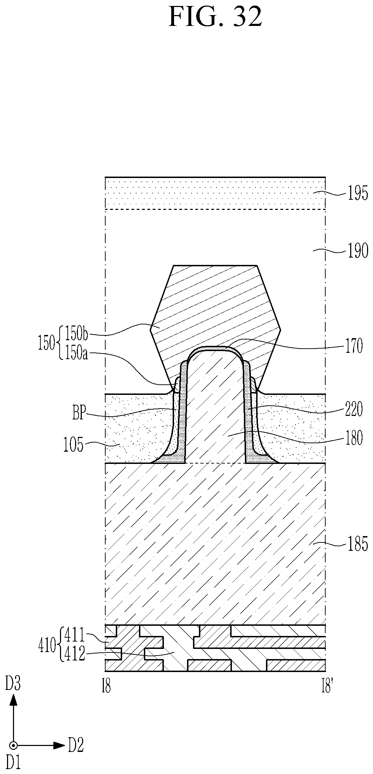

FIG. 29 illustrates a top plan view of an example of a semiconductor device. FIG. 30 to FIG. 32 illustrate example cross-sectional views of a semiconductor device. Specifically, FIG. 30 illustrates an example cross-sectional view of the semiconductor device taken along line I6-I6' of FIG. 29, FIG. 31 illustrates an example cross-sectional view of the semiconductor device taken along line I7-I7' of FIG. 29, and FIG. 32 illustrates an example cross-sectional view of the semiconductor device taken along line I8-I8' of FIG. 29.

Referring to FIG. 29 to FIG. 32, the semiconductor device may further include a lower conductive layer 185 disposed between the lower pattern BP and the lower wiring structure 410. In some implementations, the insulating liner 220 may be disposed between the lower pattern BP and the lower conductive layer 185. The semiconductor device may not include the substrate 10 (see FIG. 2 or FIG. 16). However, the present disclosure is not limited thereto, and the semiconductor device may include the substrate 10 (see FIG. 2 and FIG. 16). In this case, the insulating liner 220 may be disposed between the substrate 10 and the lower conductive layer 185.

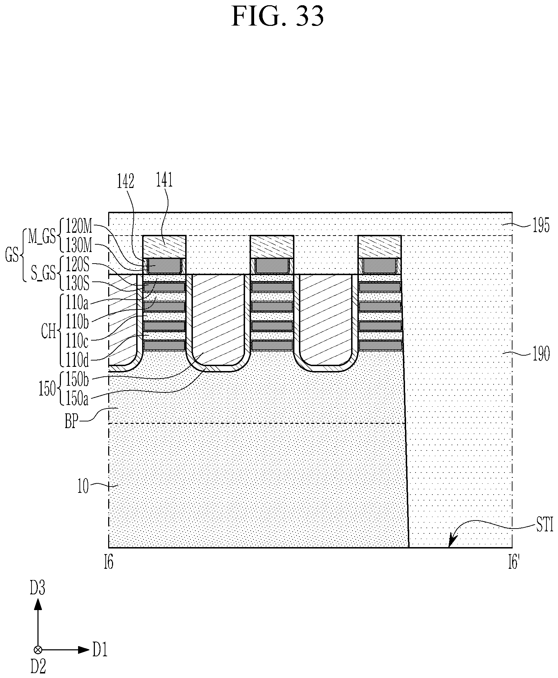

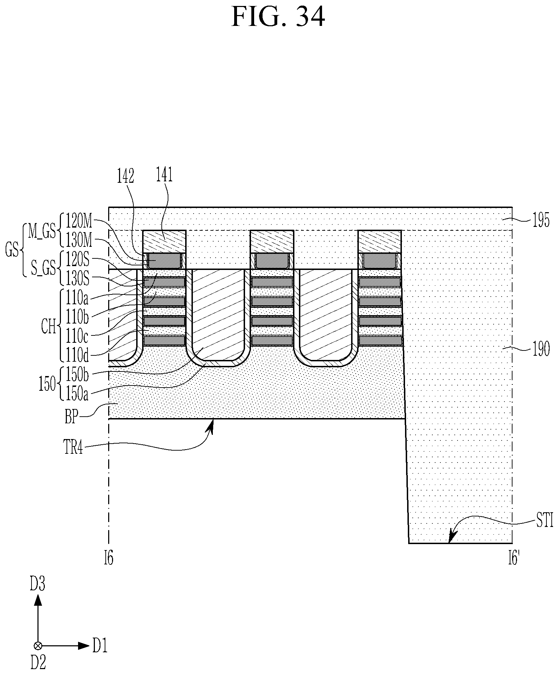

The lower conductive layer 185 may fill an area from which at least a portion of the substrate 10 (see FIG. 33 and FIG. 34), which will be described later, is removed. The lower conductive layer 185 may also be disposed below the field insulating layer 105. The upper surface of the lower conductive layer 185 may partially contact the lower surface of the insulating liner 220 and the lower surface of the through electrode 180. The upper surface of the lower conductive layer 185 may partially contact the lower surface of the field insulating layer 105. The lower surface of the lower conductive layer 185 may contact the upper surface of the lower wiring structure 410. In some implementations, the width of the lower conductive layer 185 in the horizontal direction may be wider than the width of the lower pattern BP in the horizontal direction. At least a portion of the lower surface of the lower conductive layer 185 may be electrically connected to the lower conductive patterns 411 included in the lower wiring structure 410.

The lower conductive layer 185 may include a conductive material. For example, the lower conductive layer 185 may include at least one of a metal, a metal alloy, a conductive metal nitride, a conductive metal carbide, a conductive metal oxide, a conductive metal carbonitride, and a two-dimensional (2D) material. The metal may include at least one of titanium (Ti), tantalum (Ta), tungsten W, nickel (Ni), cobalt (Co), and platinum (Pt). The conductive metal nitride may include at least one of a titanium nitride (TiN), a tantalum nitride (TaN), a tungsten nitride (WN), a nickel nitride (NiN), a cobalt nitride (CoN), and a platinum nitride (PtN).

Referring to FIG. 29 to FIG. 32, the insulating liner 220 may be disposed between the side surface of the through electrode 180 and the source/drain pattern 150, between the through electrode 180 and the lower pattern BP, and between the lower conductive layer 185 and the lower pattern BP. In the area in which the lower conductive layer 185 overlaps the lower pattern BP in the third direction D3, the insulating liner 220 may be disposed between the lower conductive layer 185 and the lower patterns BP. In the area in which the side surface of the through electrode 180 overlaps the lower pattern BP in the horizontal direction, the insulating liner 220 may be disposed between the side surface of the through electrode 180 and the lower pattern BP.

According to some implementations, the volume of the conductive material electrically connecting the source/drain pattern 150 and the lower wiring structure 410 may be increased, and thus the electrical characteristics of the semiconductor device may be improved.

In some implementations, since the insulating liner 220 is disposed between the lower conductive layer 185 and the lower pattern BP, a current flowing from the lower wiring structure 410 through the lower conductive layer 185 and the through electrode 180 may not leak into the source/drain pattern 150 by passing through the inside of the lower pattern BP.

FIG. 33 to FIG. 42 are drawings for describing an example of the method of manufacturing the semiconductor device described with reference to FIG. 29 to FIG. 32.

As shown in FIG. 33, the lower pattern BP, the channel layers CH, the gate structures GS surrounding the channel layers CH, and the source/drain patterns 150 connected to both sides of respective channel layers CH may be formed on the substrate 10. The device isolation trench STI may be formed by recessing the lower pattern BP and a portion of the substrate 10. The interlayer insulating layer 190 and/or the upper insulating layer 195 may cover the channel layers CH, the gate structures GS, and the source/drain patterns 150. The interlayer insulating layer 190 may fill the inside of the device isolation trench STI.

As shown in FIG. 34, the fourth trench TR4 may be formed by etching the substrate 10. In FIG. 34, the substrate 10 is shown as being entirely etched, but in some implementations, the substrate 10 may be partially etched. In some implementations, the substrate 10 may be removed by wet etching or dry etching.

In some implementations, the bottom surface of the fourth trench TR4 may be in contact with the lower surface of the lower pattern BP. The side surface of the fourth trench TR4 may be in contact with a partial area of the interlayer insulating layer 190 filling the device isolation trench STI.

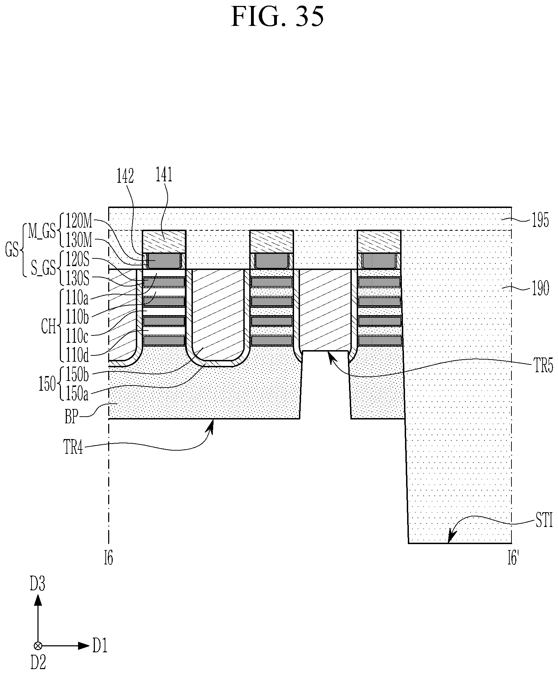

Referring to FIG. 35, a fifth trench TR5 penetrating the lower pattern BP in the third direction D3 may be formed below the source/drain pattern 150. The fifth trench TR5 may penetrate the lower pattern BP in the third direction D3 to be recessed into the inside of the source/drain pattern 150. The fifth trench TR5 may be formed by etching at least a portion of the lower pattern BP and the source/drain pattern 150. The side surface of the fifth trench TR5 may be defined by the lower pattern BP and the source/drain pattern 150. The bottom surface of the fifth trench TR5 may be defined by the source/drain pattern 150.

In some implementations, the fifth trench TR5 may be formed by a dry etching process. For example, the process of forming the fifth trench TR5 may be performed by reactive ion etching (RIE) or inductively coupled plasma (ICP). However, the present disclosure is not limited thereto, and the fifth trench TR5 may be formed by a wet etching process.

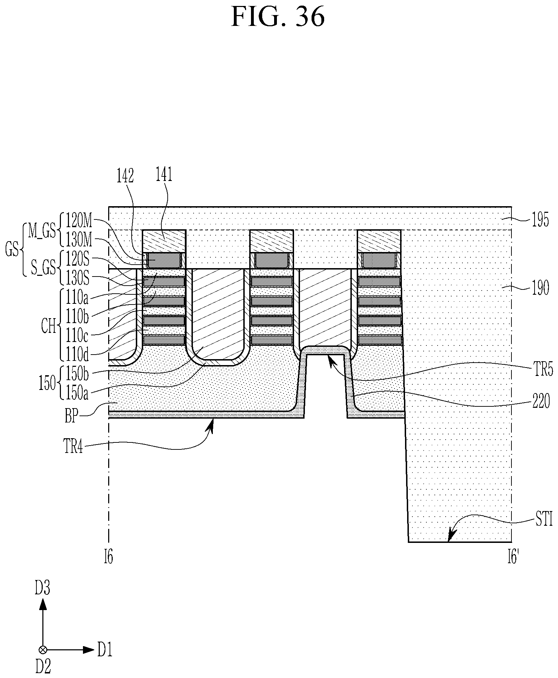

As shown in FIG. 36, the insulating liner 220 may be formed on the bottom surface of the fourth trench TR4 and the side surface and the bottom surface of the fifth trench TR5. The insulating liner 220 may extend from the bottom surface of the fourth trench TR4 to the side surface and the bottom surface of the fifth trench TR5.

The insulating liner 220 may not be disposed on the lower surface and the side surface of the interlayer insulating layer 190 filling the inside of the device isolation trench STI. In some implementations, the insulating liner 220 may be formed by diffusing from the side surface and the bottom surface of the fifth trench TR5 into the lower pattern BP and the source/drain pattern 150. The insulating liner 220 disposed on the bottom surface of the fourth trench TR4 may be formed by diffusing from the bottom surface of the fourth trench TR4 into the lower pattern BP.

In some implementations, the insulating liner 220 may be formed by growing from the side surface and the bottom surface of the fifth trench TR5 toward the inside of the fifth trench TR5. Accordingly, referring to FIG. 35 and FIG. 36, the width in the horizontal direction of the fifth trench TR5 after the insulating liner 220 is formed may be narrower than the width in the horizontal direction of the fifth trench TR5 before the insulating liner 220 is formed. In addition, the depth in the vertical direction of the fifth trench TR5 after the insulating liner 220 is formed may be shallower than the depth in the vertical direction of the fifth trench TR5 before the insulating liner 220 is formed.

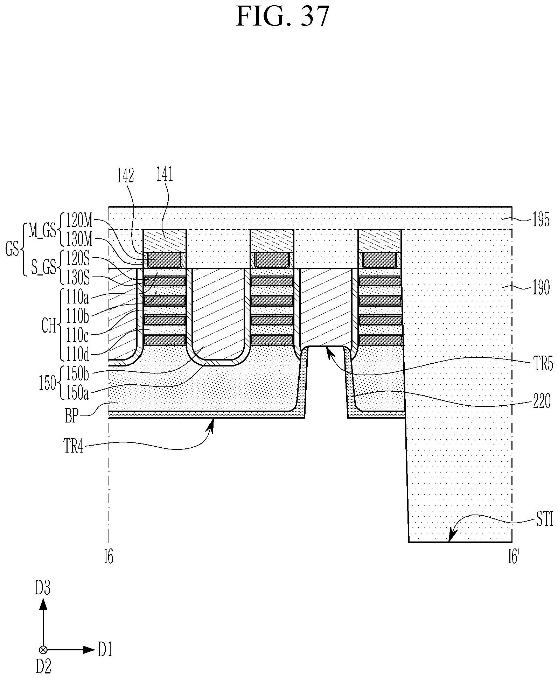

As shown in FIG. 37, a partial area of the insulating liner 220 disposed between the bottom surface of the fifth trench TR5 and the source/drain pattern 150 may be removed to expose a partial area of the source/drain pattern 150. In this case, the insulating liner 220 disposed on the side surface of the fifth trench TR5 and the bottom surface of the fourth trench TR4 may not be removed. To this end, at least one or more photolithography processes may be additionally performed.

The process of removing the partial area of the insulating liner 220 may be performed by an anisotropic etching process. For example, a partial area of the insulating liner 220 may be removed by a dry etching process using reactive ion etching (RIE) or inductively coupled plasma (ICP). However, the present disclosure is not limited thereto, and the insulating liner 220 may be removed by a wet etching process.

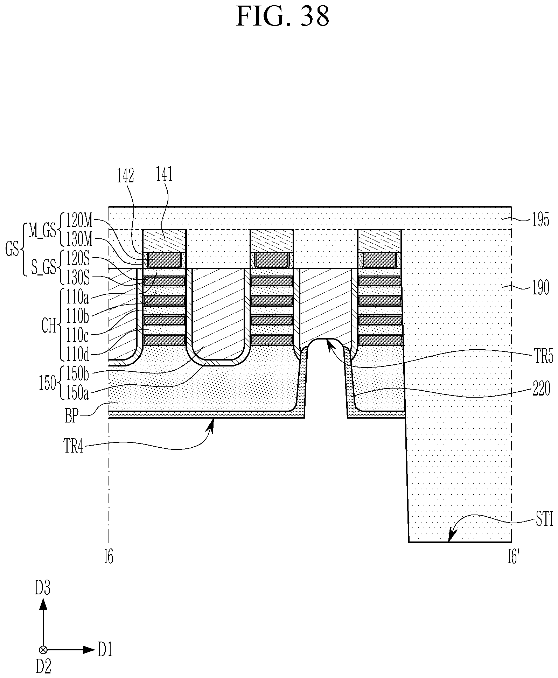

As shown in FIG. 38, a partial area of the source/drain pattern 150 exposed on the bottom surface of the fifth trench TR5 may be etched.

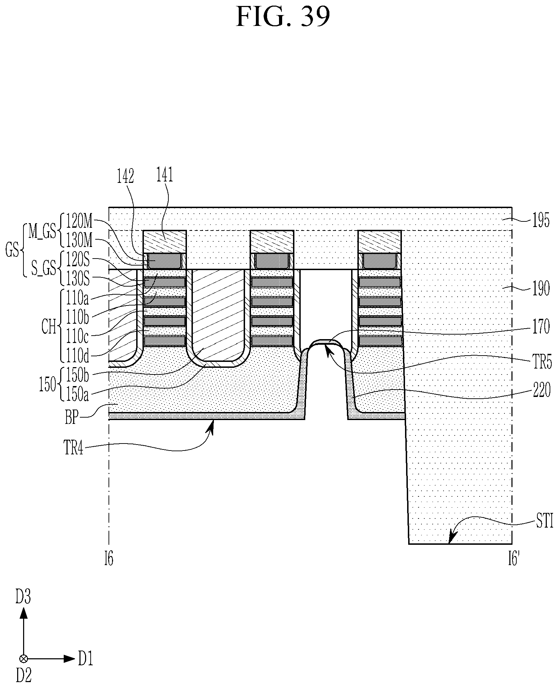

Subsequently, as shown in FIG. 39, the silicide film 170 may be formed on the bottom surface of the fifth trench TR5. The silicide film 170 may not be formed on the side surface of the fifth trench TR5. The silicide film 170 may be formed along the lower surface of the source/drain pattern 150 exposed on the bottom surface of the fifth trench TR5. The silicide film 170 may be formed, for example, by depositing a metal material on the side surface and the bottom surface of the fifth trench TR5 and then performing annealing. The silicide film 170 may be formed at an interface where the source/drain pattern 150 and the metallic material are in contact with each other. The silicide film 170 may not be formed at an interface where the insulating liner 220 and the metallic material are in contact with each other. After the silicide film 170 is formed, the metal material deposited on the side surface and the bottom surface of the fifth trench TR5 may be removed.

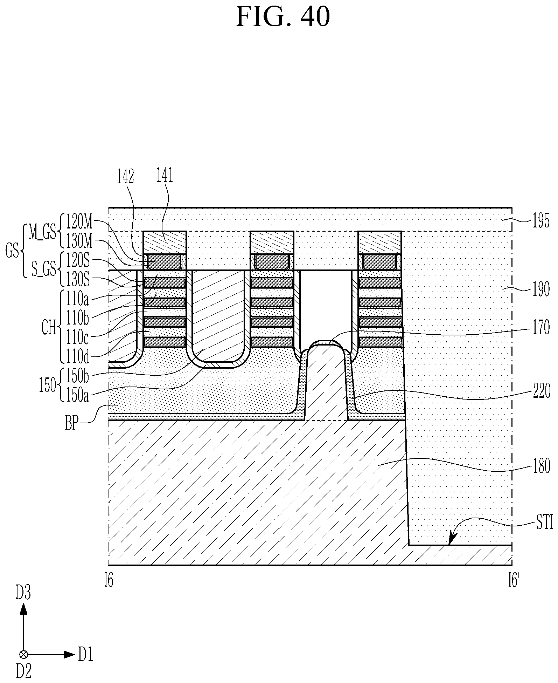

As shown in FIG. 40, the inside of the fifth trench TR5 may be filled with a conductive material to form the through electrode 180. Subsequently, the lower conductive layer 185 may be formed by filling the inside of the fourth trench TR4 with a conductive material. The lower conductive layer 185 may also be formed on the lower surface of the interlayer insulating layer 190 filling the device isolation trench STI.

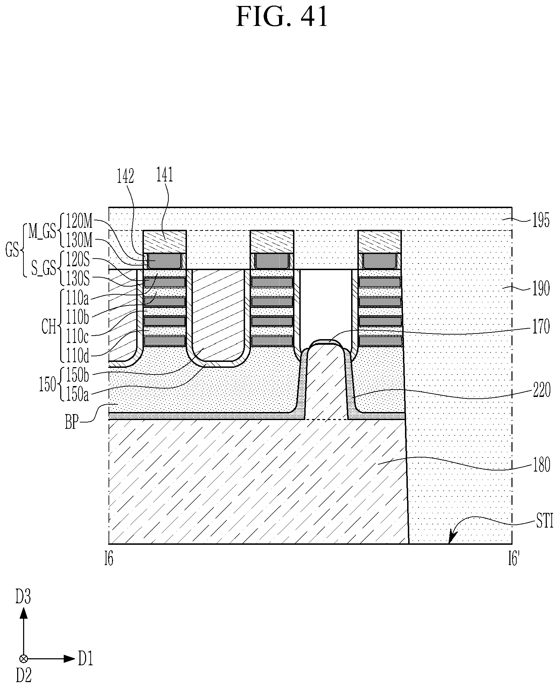

Subsequently, as shown in FIG. 41, a partial area of the lower conductive layer 185 formed on the same plane as the surface including the lower surface of the interlayer insulating layer 190 filling the device isolation trench STI may be removed. In this case, a partial area of the lower conductive layer 185 may be removed by a chemical mechanical polishing (CMP) process.

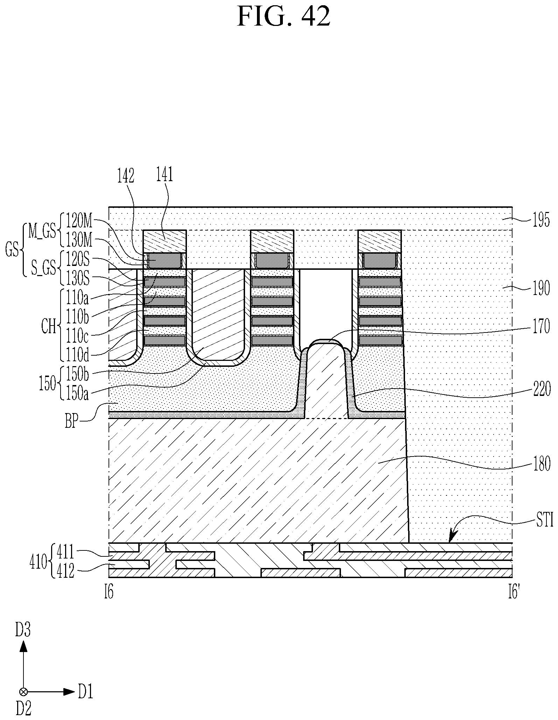

As shown in FIG. 42, the semiconductor device described with reference to FIG. 29 to FIG. 32 may be manufactured by forming a lower wiring structure 410 electrically connected to the lower conductive layer 185 on the lower surface of the lower conductive layer 185.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While some implementations of the present disclosure has been described in connection with what is presently considered to be practical implementations, it is to be understood that the disclosure is not limited to the disclosed implementations, but, on the contrary, is intended to cover various modifications and equivalent arrangements included within the scope of the appended claims.

## Claims

1. A semiconductor device comprising:
a substrate (10);
a channel layer (CH) disposed on the substrate (10);
a gate structure (GS) surrounding the channel layer (CH);
a plurality of source/drain patterns (150) connected with sides of the channel layer (CH);
a lower wiring structure (410) disposed below the substrate (10); and
an insulating pattern (210) extending through the substrate (10) and disposed between the plurality of source/drain patterns (150) below the gate structure (GS),
wherein the insulating pattern (210) includes a sub-insulating pattern (211), wherein the sub-insulating pattern includes at least a first portion which is disposed below the gate structure (GS), and a main insulating pattern (212) disposed between the first portion of the sub-insulating pattern (211) and the lower wiring structure (410), and
wherein the sub-insulating pattern (211) and the main insulating pattern (212) include different insulating materials from each other.

2. The semiconductor device of claim 1, wherein
the first portion of the sub-insulating pattern (211) has a lower surface in contact with an upper surface of the main insulating pattern (212), and
the first portion of the sub-insulating pattern (211) has a lower nitrogen concentration as a distance between the sub-insulating pattern (211) and an interface with the main insulating pattern (212) increases.

3. The semiconductor device of claim 2, wherein a width of the first portion of the sub-insulating pattern (211) in a horizontal direction toward a lower surface of the gate structure (GS) increases and then decreases as a distance between the first portion of the sub-insulating pattern (211) and the main insulating pattern (212) increases.

4. The semiconductor device of claim 2 or 3, wherein the sub-insulating pattern (211) includes a second portion which is disposed between the substrate (10) and the main insulating pattern (212).

5. The semiconductor device of claim 4, wherein the second portion of the sub-insulating pattern (211) surrounds a side surface of the main insulating pattern (212) and has a lower nitrogen concentration as a distance between the second portion of the sub-insulating pattern (211) and the side surface of the main insulating pattern (212) increases.

6. The semiconductor device of any one of claims 1 to 5, wherein the sub-insulating pattern (211) includes a silicon nitride.

7. The semiconductor device of any one of claims 1 to 6, wherein the sub-insulating pattern (211) is in contact with a lower surface of the gate structure (GS), and the main insulating pattern (212) is in contact with an upper surface of the lower wiring structure (410).

8. The semiconductor device of claim 7, wherein the sub-insulating pattern (211) includes:
a first surface in contact with the lower surface of the gate structure (GS), and
a second surface in contact with the upper surface of the main insulating pattern (212), and
wherein a distance between the first surface and the second surface is greater than or equal to 1 nm and less than or equal to 10 nm.

9. The semiconductor device of any one of claims 1 to 8, comprising:
a through electrode (180) that is disposed on a side of the insulating pattern (210), extends through the substrate (10), and connects at least one source/drain pattern of the plurality of source/drain patterns (150) with the lower wiring structure (410).

10. The semiconductor device of claim 9, comprising:
a silicide film (170) disposed between the through electrode (180) and the at least one source/drain pattern.

11. A semiconductor device comprising:
a lower pattern (BP);
a channel layer (CH) disposed on the lower pattern (BP);
a gate structure (GS) surrounding the channel layer (CH);
a plurality of source/drain patterns (150) respectively connected with sides of the channel layer (CH);
a lower wiring structure (410) disposed below the lower pattern (BP);
a through electrode (180) that extends through the lower pattern (BP) and is disposed between at least some source/drain patterns of the plurality of source/drain patterns (150) and the lower wiring structure (410); and
an insulating liner (220) including at least a first portion which is disposed between a side surface of the through electrode (180) and the lower pattern (BP),
wherein the first portion of the insulating liner (220) has a lower nitrogen concentration as a distance increases between the insulating liner (220) and the side surface of the through electrode (180) toward the lower pattern (BP).

12. The semiconductor device of claim 11, comprising:
a lower conductive layer (185) disposed between a lower surface of the lower pattern (BP) and the lower wiring structure (410),
wherein a second portion of the insulating liner (220) is disposed between the lower surface of the lower pattern (BP) and the lower conductive layer (185).

13. The semiconductor device of claim 12, wherein the second portion of the insulating liner (220) disposed between the lower surface of the lower pattern (BP) and the lower conductive layer (185) has a lower nitrogen concentration as a distance increases between the insulating liner (220) and an upper surface of the lower conductive layer (185) toward the lower pattern (BP).

14. The semiconductor device of any one of claims 11 to 13, wherein
the through electrode (180) extends through a lower portion of a first source/drain pattern of the plurality of source/drain patterns (150) into the first source/drain pattern,
a third portion of the insulating liner (220) is disposed between the side surface of the through electrode (180) and the first source/drain pattern, and
a width in a horizontal direction of the third portion of the insulating liner (220) disposed between the side surface of the through electrode (180) and the first source/drain pattern is narrower than a width in the horizontal direction of the first portion of the insulating liner (220) disposed between the side surface of the through electrode (180) and the lower pattern (BP).

15. The semiconductor device of claim 14, comprising:
a silicide film (170) disposed between an upper surface of the through electrode (180) and the first source/drain pattern.
